# EUROPEAN PATENT APPLICATION

(11) **EP 4 597 552 A1**
(43) Date of publication of application: **06.08.2025**
(21) Application number: 23882608.5
(22) Date of filing: 24.10.2023
(51) Int. Cl.: H01L 21/60, H01B 1/22, H01L 23/12

(54) **CONDUCTIVE PILLAR MODULE PRECURSOR FOR MANUFACTURING SEMICONDUCTOR, CONDUCTIVE PILLAR MODULE FOR MANUFACTURING SEMICONDUCTOR, SEMICONDUCTOR OR SEMICONDUCTOR PRECURSOR, AND METHOD FOR MANUFACTURING SAME**

(30) Priority: 24.10.2022 JP 2022169954
(71) Applicant: Dow Toray Co., Ltd., Tokyo 140-8617 (JP); Dow Global Technologies LLC, Midland, MI 48674 (US)
(72) Inventor: YAMAZAKI, Ryosuke, Ichihara-shi, Chiba 299-0108 (JP); YOSHIDA, Shin, Ichihara-shi, Chiba 299-0108 (JP); CHEN, Hsiang Chuan, Taipei City 10480 (TW)
(74) Representative: Murgitroyd & Company
(86) International application number: PCT/JP2023/038262
(87) International publication number: WO 2024/090403

(57) **Abstract**

The conventional technology cannot provide a conductive pillar module for semiconductor manufacturing that can be used for secondary wiring to a substrate of a flip chip package or for forming a redistribution layer (RDL) in a chip-last (RDL-first) package without using lithography techniques. A conductive pillar module precursor for semiconductor manufacturing, a semiconductor, or semiconductor precursor which has a structure in which a conductive pillar member is supported by a sheet-like cured resin material and provides sufficient adhesion to a substrate, stress relaxation properties, and durability, as well as a manufacturing method thereof.

## Description

### TECHNICAL FIELD

The present invention relates to a conductive pillar module precursor for semiconductor manufacturing, a conductive pillar module for semiconductor manufacturing, a semiconductor or a semiconductor precursor, and a method for manufacturing the same.

### BACKGROUND ART

In semiconductor manufacturing, flip chip packaging technology, which uses solder bumps to connect a chip to a substrate, has been used for about 30 years. In recent years, semiconductor devices and the like have become increasingly miniaturized, and miniaturization of substrate structures has become common. However, the use of solder bumps is subject to pitch restrictions. Therefore, when scaling below 100 µm, copper pillar interconnects are used to enable finer pitches with high I/O (input/output) density.

Patent Document 1 discloses a method for manufacturing copper pillar wiring using flip chip packaging technology and resist technology.

However, the method described in Patent Document 1 requires lithography techniques for forming and removing a photoresist layer, which lengthens the manufacturing time and increases the number of steps, resulting in high costs.

Therefore, there is need for a manufacturing method that is simpler than the conventional techniques, thereby shortening the manufacturing steps and time, and reducing the cost of semiconductor manufacturing.

Additionally, the resin used in the conductive pillar module must have a coating that adheres well to metal and can be blasted. In addition, in the case of flip chip packages, durability after reflow is required, and in the case of fanout packages, which is another semiconductor manufacturing method, suitability for subsequent processes depending on the application, such as applicability to an RDL (redistribution layer) formation process, is required. Therefore, the resin used in the conductive pillar module is required to have adhesion to various substrates, stress relaxation properties, and durability.

On the other hand, curable silicone compositions can be cured to form cured materials having excellent heat resistance, cold resistance, electrical insulation, weather resistance, water repellency, and transparency, and are utilized in a wide range of industrial fields. In particular, the cured material of the curable silicone composition is generally applicable as a sealing agent for a semiconductor device because discoloration is less likely to occur as compared with other organic materials and there is less deterioration of physical properties over time.

The present applicant has proposed, in Patent Document 2 and Patent Document 3, a so-called hot-melt curable granular silicone composition and a reactive silicone composition for molding. These silicone compositions contain a large amount of inorganic filler to achieve these properties, and the melt viscosity is relatively high.

In recent years, a low viscosity is required during sealing in order to seal the miniaturized substrate in conjunction with the miniaturization of the semiconductor devices. Furthermore, with the recent trend toward larger surface area of semiconductor devices, there is a tendency for film- or sheet-shaped sealants to be preferred, and the same is true for resin compositions used in conductive pillar modules. The aforementioned hot-melt curable granular silicone compositions and reactive silicone compositions for molding, which have a relatively high melt viscosity, are not suitable as sheet-shaped resin compositions for use in conductive pillar modules.

### RELATED ART DOCUMENTS

### PATENT DOCUMENTS

Patent Document 1: Japanese Unexamined Patent Application 2017-17300
Patent Document 2: International Patent Publication No. 2016/136243
Patent Document 3: International Patent Publication No. 2019/078140

### SUMMARY OF THE INVENTION

### PROBLEM TO BE SOLVED BY THE INVENTION

Therefore, with the conventional technology, a conductive pillar module for semiconductor manufacturing that can be used for secondary wiring to a substrate of a flip chip package or for forming a redistribution layer (RDL) in a chip-last (RDL-first) package without using lithography techniques has not been obtained.

In light of the foregoing, an object of the present invention is to provide a conductive substrate module precursor for semiconductor production, a conductive pillar module for semiconductor manufacturing, a semiconductor or a semiconductor precursor, and a method for manufacturing the same, which have sufficient adhesion to a substrate, stress relaxation properties, and durability.

### MEANS FOR SOLVING THE PROBLEM

As a result of conducting diligent research on the problem described above, the present inventors arrived at the present invention. In other words, the object of the present invention is achieved by a conductive pillar module precursor for semiconductor manufacturing, which has a structure in which a conductive pillar member is supported by a sheet-like cured resin material.

In the conductive pillar module precursor for semiconductor manufacturing of the present invention, the sheet-like cured resin material is preferably a silicone cured material, and the conductive pillar member is preferably a conductive pillar having a minor axis length of 50 to 500 µm and a major axis length of 50 to 500 µm.

The conductive pillar module precursor for semiconductor manufacturing of the present invention is a silicone cured material obtained by curing a sheet-like cured resin material by a hydrosilylation reaction, and the conductive pillar member is preferably a cylindrical copper pillar having a diameter of 50 to 500 µm and a height of 50 to 2000 µm.

The present invention also relates to a conductive pillar module for semiconductor manufacturing, which has a structure in which a conductive pillar member is supported by a sheet-like cured resin material and the conductive pillar member is exposed from both sides of the sheet-shaped cured resin material.

The present invention also relates to a semiconductor or semiconductor precursor having a structure in which at least a portion of the conductive pillar members of the conductive pillar module for semiconductor manufacturing of the present invention are soldered onto a substrate, and the conductive pillars exposed from the opposite surface of the sheet-like cured resin material are bonded to a semiconductor chip directly or via a conductive layer (redistribution layer).

The semiconductor or semiconductor precursor of the present invention preferably has a structure in which the gaps between the substrate, the semiconductor chip and the conductive pillar members are filled with a mold underfill material.

The present invention also relates to a method for manufacturing a semiconductor or a semiconductor precursor, which includes a step of bonding a conductive pillar member exposed from the conductive pillar module precursor for semiconductor manufacturing of the present invention to a semiconductor chip or substrate.

The present invention also relates to a method for manufacturing a conductive pillar module precursor for semiconductor manufacturing of the present invention, including the following steps (I) to (IV):
Step (I): a step of providing a conductive pillar member on a mold member;
Step (II): a step of providing at least one curable resin composition and, optionally, a release liner on the conductive pillar member;
Step (III): a step of curing the curable resin composition into a sheet shape by one or more curing means selected from heating and high energy beam radiation; and
Step (IV): a step of separating the conductive pillar module precursor for semiconductor manufacturing from the mold member, optionally after removing the release liner.

With the manufacturing method of a conductive pillar module precursor for semiconductor manufacturing of the present invention, the curable resin composition used in Step (II) is preferably a sheet of the curable resin composition having heat-melting properties, where the sheet of the curable resin composition is placed on a conductive pillar member, and then the sheet of the curable resin composition is heated and melted to support at least a portion of the conductive pillar inside the sheet of the curable resin composition.

With the method for manufacturing a conductive pillar module precursor for semiconductor manufacturing of the present invention, the curable resin composition used in Step (II) is preferably a hydrosilylation reaction-curable silicone sheet having heat-melting properties, and the hydrosilylation reaction-curable silicone sheet is placed on a conductive pillar member, and then the hydrosilylation reaction-curable silicone sheet is heated and melted to support at least a portion of the conductive pillar member inside the sheet of the curable resin composition; and
Step (III) is preferably a step of curing the hydrosilylation-curable silicone sheet in a sheet form by one or more curing means selected from the group consisting of heating and high energy beam radiation.

The method for manufacturing a conductive pillar module precursor for semiconductor manufacturing of the present invention preferably further includes, after the aforementioned Step (IV), a step of bonding the optionally exposed conductive pillar member to a semiconductor chip or substrate, and then scraping off at least one surface of the sheet-like cured resin material to expose the conductive pillar on both surfaces of the sheet-like cured resin.

The present invention also relates to a method for manufacturing a conductive pillar module precursor for semiconductor manufacturing of the present invention, including the following steps (I') to (V'):
Step (I'): a step of providing a conductive pillar member on a first mold member;
Step (II'): a step of placing a second mold member on the conductive pillar member;
Step (III'): a step of filling gaps between the conductive pillar member, the first molding member, and the second molding member with a curable resin composition;
Step (IV'): a step of curing the curable resin composition into a sheet shape by one or more curing means selected from heating and high energy beam radiation; and
Step (V'): a step of separating the first molding member and the second molding member from the conductive pillar module precursor for semiconductor manufacturing.

The present invention also relates to a method for manufacturing a semiconductor or a semiconductor precursor, including the following steps (L1) to (L5):
Step (L1): a step of bonding the conductive pillar module precursor for semiconductor manufacturing of the present invention to a carrier member;
Step (L2): a step of bonding a semiconductor chip to a conductive pillar member on one side of the conductive pillar module precursor for semiconductor manufacturing, with the conductive pillar member being exposed from the sheet-like cured resin material;
Step (L3): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4): a step of soldering the conductive pillar member exposed in step (L3) to a substrate; and
Step (L5): a step of filling the gaps between the substrate, the semiconductor chip, and the conductive pillar member with a mold underfill material.

The present invention also relates to a method for manufacturing a semiconductor or a semiconductor precursor, including the following steps (L1') to (L5'):
Step (L1'): a step of bonding the conductive pillar module precursor for semiconductor manufacturing of the present invention to a carrier member;
Step (L2'): a step of bonding to the substrate by soldering the conductive pillar member on one side of the conductive pillar module precursor for semiconductor manufacturing, the conductive pillar member being exposed from the sheet-like cured resin material;
Step (L3'): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4'): a step of bonding the conductive pillar exposed in step (L3') to a semiconductor chip, either directly or via a conductive layer (redistribution layer); and
Step (L5'): a step of filling the gaps between the substrate, the semiconductor chip, and the conductive pillar with a mold underfill material.

### EFFECT OF THE INVENTION

The conductive pillar module precursor for semiconductor manufacturing or the conductive pillar module for semiconductor manufacturing of the present invention can be used for secondary wiring to a substrate of a flip chip package or for forming a redistribution layer (RDL) in a chip-last (RDL-first) package, and has excellent adhesion to the substrate, stress relaxation properties and durability. Furthermore, a semiconductor or semiconductor precursor can be provided using the conductive pillar module.

The method for manufacturing a conductive pillar module precursor for semiconductor manufacturing, or the method for manufacturing a semiconductor or a semiconductor precursor of the present invention can provide a manufacturing method that does not use lithography technology and requires fewer steps and less time.

### BRIEF DESCRIPTION OF THE DRAWINGS

FIG. 1 is an embodiment of a conductive pillar module precursor for semiconductor manufacturing of the present invention;
FIG. 2 is an embodiment of a conductive pillar module for semiconductor manufacturing according to the present invention;
FIG. 3 is an embodiment of a semiconductor or semiconductor precursor of the present invention;
FIG. 4 is an embodiment of a semiconductor or semiconductor precursor of the present invention;
FIG. 5 is an embodiment of a method for manufacturing for a conductive pillar module precursor for semiconductor manufacturing of the present invention;
FIG. 6 is an embodiment of a conductive pillar module precursor manufactured by the method for manufacturing a conductive pillar module precursor for semiconductor manufacturing of the present invention;
FIG. 7 is an embodiment of a method for manufacturing for a conductive pillar module precursor for semiconductor manufacturing of the present invention;
FIG. 8 is an embodiment of a method for manufacturing a semiconductor or semiconductor precursor of the present invention by flip chip packaging;
FIG. 9 is an embodiment of a method for manufacturing a semiconductor or semiconductor precursor of the present invention with a chip-last package using an RDL (redistribution layer).
FIG. 10 is a diagram depicting the overall configuration of the manufacturing device (all parts, including sheet forming) of the curable silicone sheet used in the examples; and
FIG. 11 depicts the results of checking the warping of the structure and the movement of the conductive pillars after placing the structure obtained in the example in an oven set at 250°C for 30 seconds.

### DESCRIPTION OF THE PREFERRED EMBODIMENTS

Embodiments of the present invention will be described below in detail. The present invention is not limited by the following embodiments, and various types of modifications may be made within the scope of the gist of the present invention.

In the present invention, atmospheric pressure refers to the atmospheric pressure in the environment where the curable silicone composition is handled in a laboratory, factory, or the like, and although not limited to a specific pressure, usually refers to atmospheric pressure in a range of minus 100 hPa to plus 100 hPa from 1 atm (1013.25 hPa), and particularly 1 atm (1013.25 hPa).

In the present specification, room temperature refers to the temperature of the environment in which someone handles the conductive pillar module precursor for semiconductor manufacturing of the present invention. Room temperature typically refers to 0°C to 40°C, particularly refers to 15 to 30°C, and more particularly refers to 18°C to 25°C.

### [Conductive pillar module precursor for semiconductor manufacturing]

Hereinafter, first, the conductive pillar module precursor for semiconductor manufacturing of the present invention will be described in detail. The conductive pillar module precursor for semiconductor manufacturing of the present invention has a structure in which a conductive pillar member is supported by a sheet-like cured resin material.

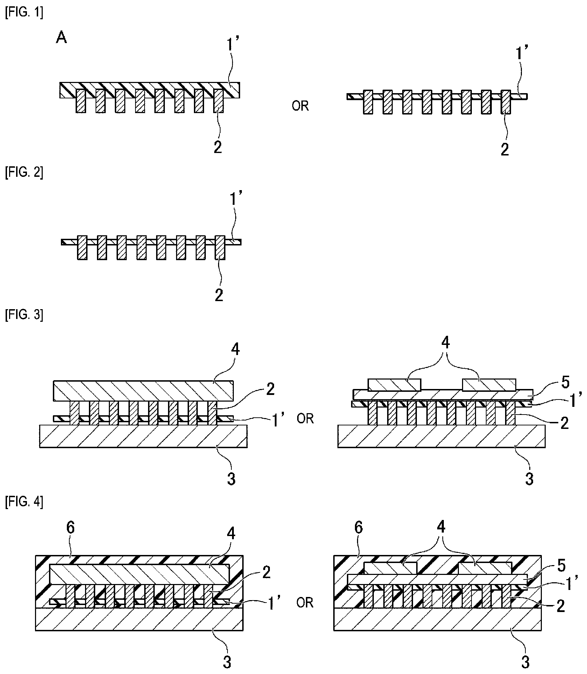

FIG. 1 depicts an embodiment of a conductive pillar module precursor for semiconductor manufacturing (A) of the present invention. The conductive pillar module precursor for semiconductor manufacturing of the present invention has a structure in which a plurality of conductive pillar members (2) are supported on a sheet-like cured resin material (1'). The supported structure refers to a structure in which the conductive pillar member (2) is exposed from at least one surface of the sheet-like cured resin material (1').

The sheet-like cured resin material may be a cured material made of the curable silicone composition.

The curable silicone composition may contain:
(A) 100 parts by mass of an organopolysiloxane resin containing the following component (A1) and component (A2) in a mass ratio of 20:80 to 90:10, where the mass loss rate is 2.0 mass% or less after 1 hour exposure at 200°C;
(A1) an organopolysiloxane resin that is solid at 25°C, having a curing reactive functional group containing a carbon-carbon double bond in a molecule, containing 20 mol% or more of a siloxane unit as expressed by SiO_{4/2} of all siloxane units, and not independently having hot-melt properties;
(A2) an organopolysiloxane resin that is solid at 25°C, not having a curing reactive functional group containing a carbon-carbon double bond in a molecule, containing 20 mol% or more of a siloxane unit as expressed by SiO_{4/2} of all siloxane units, and not independently having hot-melt properties;
(B) 10 to 100 mass parts of a straight chain or branched organopolysiloxane that is liquid or has plasticity at 25°C, having at least two curing reactive functional groups having a carbon-carbon double bond in a molecule; and
(C) an organohydrogenpolysiloxane having at least two silicon-bonded hydrogen atoms in a molecule at an amount where the number of hydrogen atoms bonded to a silicon atom per one alkenyl group bonded to a silicon atom included in the entire composition is 0.5 to 20.0; such that the composition as a whole has hot-melt properties.

In the present invention, unless otherwise stated, "having hot-melt properties" means the softening point of a composition is between 50 and 200°C, and the composition has a melt viscosity at 100°C of 1 to 500 Pa·s) and has flowable properties. Therefore, in the present specification, the curable silicone composition having hot-melt properties is also referred to as a curable hot-melt silicone composition.

**In** other words, the curable hot-melt silicone composition of the present invention is a heat curable silicone composition that uses a hydrosilylation reaction, containing as main components:
(component (A)) a combination of
(A1) an organopolysiloxane resin having a mass loss ratio of 2.0 mass% or less when exposed for 1 hour at 200°C, containing a curing reactive functional group including a carbon-carbon double bond in the molecule, containing siloxane units (hereinafter referred to as "Q units") expressed by SiO_{4/2} accounting for 20 mol% or more of all siloxane units, that does not independently have hot-melt properties, and that is solid at 25°C, and
(A2) an organopolysiloxane resin having a mass loss ratio of 2.0 mass% or less when exposed for 1 hour at 200°C, not containing a curing reactive functional group including a carbon-carbon double bond in the molecule, containing Q units accounting for 20 mol% or more of all siloxane units, that does not independently have hot-melt properties, and that is solid at 25°C,
at a mass ratio of (A1):(A2) = 20:80 to 90:10, or 35:65 to 90:10, or 50:50 to 90:10; and
(component (B)) a straight or branched organopolysiloxane containing a carbon-carbon secondary bond, that is liquid or has plasticity at 25°C; and also containing:
   (component (C)) organohydrogenpolysiloxane as a crosslinking agent. In addition, in the curable hot-melt silicone composition, a hydrosilylation reaction retarding agent, a so-called cure retarding agent, may be used by optional selection, but in that case, a cure retarding agent with a boiling point of 200°C or higher, in particular, a boiling point of 200°C or higher under one atmosphere of pressure (1,013.25 hPa) is preferably used. Furthermore, the curable hot-melt silicone composition may have other additives known in the art, added within a scope where the properties intended by the present invention can be maintained.

### [Hot-Melt Properties and Composition of Curable Silicone Compositions]

The curable silicone composition has hot-melt properties as a whole and can flow under heated conditions. In particular, the curable silicone composition preferably has a softening point of 50°C or higher and melt viscosity at 150°C (preferably, a melt viscosity that is less than 200 Pa-s when measured using a Koka flow meter as described below). Note that in the present invention, only the composition as a whole needs to have hot-melt properties, and individual components forming the composition (Component (A) in particular) do not have hot-melt properties.

### [Component (A)]

The mass loss ratio of component (A) when exposed to 200°C for one hour must be 2.0 mass% or less in order to minimize the surface stickiness (surface tack) of the cured material obtained by curing the present composition and to suppress a change in the modulus of elasticity of the cured material at high temperature.

The curable silicone composition has, as component (A), a combination of an organopolysiloxane resin that is solid at 25°C, having a curing reactive functional group that contains a carbon-carbon double bond, containing Q units accounting for 20 mol% or more of all siloxane units, and not exhibiting hot-melt properties alone, and an organopolysiloxane resin that is a solid at 25°C, not having a curing reactive functional group that contains a carbon-carbon double bond, containing Q units accounting for 20 mol% or more of all siloxane units, and not exhibiting hot-melt properties alone, at a mass ratio of 20:80 to 90:10, or 35:65 to 90:10, or 50:50 to 90:10. The organopolysiloxane resin may further contain a siloxane unit expressed by R₃SiO_{1/2}, R₂SiO_{2/2}, or RSiO_{3/2} (R independently represents a monovalent organic group, and particularly a monovalent hydrocarbon group with 1 to 10 carbon atoms), or a hydroxyl group, or an alkoxy group expressed by R²O_{1/2} (R² represents a hydrogen atom or an alkyl group having 1 to 10 carbon atoms), but preferably includes Q units accounting for 20 mol% or more, preferably 40 mol% or more, and particularly preferably within a range of 40 to 90 mol% of all siloxane units. If the amount of Q units is less than 20 mol%, a technical effect of the present invention may not be achieved even if the organopolysiloxane resin contains a large amount of another branched siloxane unit (for example, RSiO_{3/2}), for example.

The organopolysiloxane resin (A) is an organopolysiloxane resin mixture containing:
(A1) an organopolysiloxane resin that is solid at 25°C, having a curing reactive functional group containing a carbon-carbon double bond in a molecule, containing at least 20 mol% or more of Q units of all siloxane units, and not independently having hot-melt properties; and
(A2) an organopolysiloxane resin that is solid at 25°C, not having a curing reactive functional group containing a carbon-carbon double bond in a molecule, containing at least 20 mol% or more of Q units of all siloxane units, and not independently having hot-melt properties,
at a mass ratio (component (A1): component (A2)) of 20:80 to 90:10, or 35:65 to 90:10, or 50:50 to 90:10. Here, curing reactive refers to being capable of reacting with organohydrogensiloxane of component (C) by hydrosilylation reaction, thereby enabling the entire composition to be cured, and also refers to a curing reactive functional group containing a carbon-carbon double bond in the molecule, such as an alkenyl group, an acryloxy group, and the like.

Although component (A) described above does not have hot-melt properties alone, the composition overall can have hot-melt properties by concomitant use of component (B) described later in a prescribed quantitative ratio range.

### [Organopolysiloxane Resin (A1) Having Curing Reactive Functional Group]

Component (A1) described above is one base compound of the present composition, and is an organopolysiloxane resin that contains Q units accounting for at least 20 mol% or more of all siloxane units, has no hot-melt properties alone, and has a curing reactive functional group containing a carbon-carbon double bond in a molecule.

Component (A1) must have a curing reactive group having a carbon-carbon double bond in a molecule. Such a curing reactive group is a hydrosilylation reactive functional group, which can form a cured material by a hydrosilylation cross-linking reaction with component (C). These curing reactive groups may be alkenyl groups, especially alkenyl groups with 2 to 10 carbons, such as vinyl groups and hexenyl groups.

Component (A1) is an organopolysiloxane resin that independently does not have hot-melt properties and is solid in a solvent-free state. Herein, the absence of hot-melt properties means that the organopolysiloxane resin, which is component (A1), does not exhibit heating and melting behavior independently at 200°C or lower, and specifically means that the component does not have a softening point or melt viscosity at a temperature of 200°C or lower. In order to exhibit such properties, the component (A1) has a functional group in the organopolysiloxane resin that is a functional group selected from monovalent hydrocarbon groups with 1 to 10 carbon atoms, and particularly methyl groups and other alkyl groups with 1 to 10 carbon atoms, and does not substantially contain a phenyl group or other aryl group. For example, the ratio of aryl groups in all organic groups bonded to silicon atoms is 5 mol% or less, or 2 mol% or less, but preferably no aryl groups are included at all. If component (A1) contains a large amount of aryl groups such as a phenyl group as an organic group, the component may independently be hot-meltable, and the effect of reinforcing a cured material derived from Q units may be reduced.

Preferably, the functional group bonded to a silicon atom in the organopolysiloxane resin of component (A1) is a group selected from methyl groups or alkenyl groups such as a vinyl group. 70 to 99 mol% of all organic groups bonded to silicon atoms may be methyl groups. Other organic groups bonded to a silicon atom may be an alkenyl group such as a vinyl group. In such a range, component (A1) is not hot-meltable alone, but is useful as a component that is particularly excellent in coloring resistance and the like at the high temperatures of a cured material obtained from the curable silicone composition. Note that the organopolysiloxane resin of component (A1) may contain a small amount of a hydroxyl group or alkoxy group.

Component (A1) is an organopolysiloxane resin that is solid in the absence of a solvent, and preferably, component (A1) is an organopolysiloxane resin that is solid at 25°C and does not independently have hot-melt properties, expressed by
(A1-1) the following average unit formula:

(R¹₃SiO_{1/2})ₐ(R¹₂SiO_{2/2})_{b}(R¹SiO_{3/2})c(SiO_{4/2})_{d}(R²O_{1/2})ₑ

(where each R¹ independently represents a monovalent hydrocarbon group with 1 to 10 carbon atoms, but 1 to 12 mol% of all R¹s in a molecule represents an alkenyl group; each R² represents a hydrogen atom or an alkyl group with 1 to 10 carbon atoms; and a, b, c, d, and e represent numbers that satisfy 0.10 ≤ a ≤ 0.60, 0 ≤ b ≤ 0.70, 0 ≤ c ≤ 0.80, 0.20 ≤ d ≤ 0.65, 0 ≤ e ≤ 0.05, but 0.20 ≤ c + d, and a + b + c + d = 1).

In the aforementioned average unit formula, each R¹ independently represents a monovalent hydrocarbon group having 1 to 10 carbon atoms. Examples include: methyl groups and other alkyl groups; vinyl groups and other alkenyl groups; and phenyl groups and other aryl groups. Furthermore, 1 to 12 mol% of all R¹s in one molecule are alkenyl groups, and 2 to 10 mol% of all R¹s in one molecule are alkenyl groups, and particularly preferably a vinyl group. If the alkenyl group content is less than the lower limit of the range described above, the mechanical strength (hardness and the like) of the resulting cured material may be insufficient. On the other hand, if the amount of the alkenyl group is at or below the upper limit of the range described above, the composition containing the component can achieve favorable hot-melt performance as an entire composition.

In the formula above, R² is a hydrogen atom or an alkyl group having 1 to 10 carbon atoms. Examples of alkyl groups in R² include methyl groups. The group R²O_{1/2} containing R² corresponds to a hydroxyl group or alkoxy group of the organopolysiloxane resin of component (A).

In the formula, "a" is a number indicating the percentage of siloxane units in the general formula: R¹₃SiO_{1/2}. "a" satisfies 0.1 ≤ a ≤ 0.60, and satisfies 0.15 ≤ a ≤ 0.55. If "a" is at or above the lower limit of the aforementioned range, the composition containing the component can achieve favorable hot-melt performance as a whole composition. On the other hand, if "a" is less than or equal to the upper limit of the aforementioned range, the mechanical strength (hardness, elongation rate, and the like) of the cured material obtained by curing the curable silicone composition is not too low.

In the formula, "b" is a number indicating the percentage of siloxane units in the general formula: R¹₂SiO_{2/2}. "b" is a value that satisfies 0 ≤ b ≤ 0.70, and satisfies 0 ≤ b ≤ 0.60. If "b" is less than or equal to the upper limit of the aforementioned range, the composition containing the component can achieve favorable hot-melt performance as a whole composition and a composition with little stickiness at room temperature can be obtained.

In the formula above, "c" represents a number indicating the percentage of siloxane units in the general formula: R³SiO_{3/2}. "c" is a value that satisfies 0 ≤ c ≤ 0.80, and satisfies 0 ≤ c ≤ 0.75. If "c" is less than or equal to the upper limit of the aforementioned range, the composition containing the component can achieve favorable hot-melt performance as a whole composition and a low-tack or tack-free composition with little stickiness at room temperature can be obtained. In the present invention, c may be and is preferred to be 0.

In the above formula, d is a number indicating the ratio of Q units, and may be such that 0.20 ≤ d ≤ 0.65, or 0.25 ≤ d ≤ 0.65. If "d" is within the aforementioned numerical value range, the composition containing this component can achieve favorable hot-melt performance as a whole composition, and a cured material obtained by curing the composition can be relatively hard and have sufficient flexibility for practical use.

In the formula above, "e" is a number indicating the percentage of units in the general formula: R²O_{1/2}, where the units are a hydroxyl group or alkoxy group bonded to a silicon atom that can be included in the organopolysiloxane resin. "e" satisfies the equation 0 ≤ e ≤ 0.05, and preferably satisfies 0 ≤ e ≤ 0.03. If "e" is below the upper limit of the range, a material that achieves favorable hot-melt performance as an entire composition can be obtained. Note that in the formula above, the sum of "a", "b", "c", and "d", which is the sum of each siloxane unit, is equal to 1.

Component (A1) is an organopolysiloxane resin having the aforementioned properties, and is a solid at room temperature, so in order to physically blend with component (B) described below, component (A1) may be used in a state dissolved in a solvent or solvent mixture selected from the group consisting of: toluene, xylene, mesitylene, and other aromatic hydrocarbons; tetrahydrofuran, dipropyl ether, and other ethers; hexamethyldisiloxane, octamethyltrisiloxane, decamethyltetrasiloxane, and other silicones; ethyl acetate, butyl acetate, propylene glycol monomethyl ether acetate, and other esters; acetone, methyl ethyl ketone, methyl isobutyl ketone, and other ketones; and the like. The solvent used herein can be efficiently removed in a process described later.

### [Component (A2)]

Component (A2) is one base compound of the present composition, is an organopolysiloxane resin that is solid at 25°C, not having hot-melt properties alone and not containing a curing reactive functional group, and is a component for achieving hot-melt properties of the curable silicone composition as a whole and excellent stress relaxation properties of a cured material obtained by curing the curable silicone composition through use in combination with component (A1) and component (B) described above within a prescribed quantitative range.

Component (A2) is an organopolysiloxane resin that independently does not have hot-melt properties and is solid in a solvent-free state. The behavior of component (A2) not having hot-melt properties and the absence of an aryl group, such as a phenyl group, is similar to that of component (A1).

Component (A2) is an organopolysiloxane resin which, similar to component (A1), is a solid at 25°C and contains Q units accounting for 20 mol% or more of all siloxane units, but does not have a curing reactive functional group containing at least one carbon-carbon double bond in a molecule. In other words, component (A2) does not contain an alkenyl group such as a vinyl group or the like as a functional group in the organopolysiloxane resin. Examples of groups provided by the organopolysiloxane resin of component (A2) include monovalent hydrocarbon groups with 1 to 10 carbon atoms, and particularly methyl groups and other alkyl groups with 1 to 10 carbon atoms. The organopolysiloxane resin must be substantially free of phenyl groups or other aryl groups. For example, the ratio of aryl groups of all organic groups bonded to a silicon atom is 5 mol% or less, or 2 mol% or less, and preferably no aryl groups are included at all.

Preferably, the functional group bonded to the silicon atom in component (A2) is an alkyl group having 1 to 10 carbon atoms, such as a methyl group, and 70 to 100 mol% of all organic groups bonded to a silicon atom may be methyl groups. Within this range, component (A2) can be a component that does not individually exhibit hot-melt properties, and that is particularly effective in reinforcing a cured material containing siloxane units expressed by SiO_{4/2}. Note that the organopolysiloxane resin of component (A2) may contain a small amount of a hydroxyl group or alkoxy group.

Component (A2) does not have a curing reactive functional group having a carbon-carbon double bond in a molecule, and thus independently does not form a cured material when combined with organohydrogenpolysiloxane, which is component (C), but improves the hot-melt properties of the curable silicone composition and has a reinforcing effect with regard to cured material obtained by curing the curable silicone composition. Furthermore, the hot-melt properties of the resulting curable silicone composition and the physical properties of the composition after curing can be adjusted, if necessary, by using component (A1) having a curing reactive functional group.

Component (A2) is an organopolysiloxane resin that is solid at 25°C in a solvent-free state, and 20 mol% or more of all siloxane units in each molecule are Q units which are branched siloxane units. Preferably, the ratio of Q units to all of the organopolysiloxane of component (A2) is 40 mol% or more, or 50% or more, and particularly within a range of 50 to 65 mol%.

Preferably, component (A2) is an organopolysiloxane resin which does not independently have hot-melt properties, having the average unit formula:

(R³₃SiO_{1/2})_{f}(R³₂SiO_{2/2})_{g}(R³SiO_{3/2})ₕ(SiO_{4/2})ᵢ(R²O_{1/2})ⱼ

(where each R³ independently represents a monovalent hydrocarbon group with 1 to 10 carbon atoms and that does not contain a carbon-carbon double bond; R² represents a hydrogen atom or an alkyl group with 1 to 10 carbon atoms; and f, g, h, i, and j represent numbers that satisfy 0.35 ≤ f ≤ 0.55, 0 ≤ g ≤ 0.20, 0 ≤ h ≤ 0.20, 0.45 ≤ i ≤ 0.65, 0 ≤ j ≤ 0.05, and f + g + h + i = 1).

In the average unit formula above, each R³ independently represents a monovalent hydrocarbon group having 1 to 10 carbon atoms and containing no carbon-carbon double bond. Examples includes groups selected from a group consisting of methyl groups and other alkyl groups; phenyl groups and other aryl groups; and benzyl groups and other aralkyl groups. Herein, it is particularly preferred from the perspective of industrial production and the technical effect of the invention that 70 mol% or more of the total R³ in one molecule is a methyl group or other alkyl group with 1 to 10 carbon atoms, and particularly a methyl group. On the other hand, R³ is preferably substantially free of phenyl groups and other aryl groups. If a large amount of phenyl groups or other aryl groups are included, component (A2) itself may have hot-melt properties, the technical effect of the present invention may not be achieved, and the coloring resistance under high temperatures of a cured material obtained by curing the curable silicone composition may deteriorate.

In the formula above, R² is as described above, but when R² represents an alkyl group, an example of the alkyl group is a methyl group.

In the formula, "f" is a number indicating the percentage of siloxane units of the general formula: R³₃SiO_{1/2}. f is a value that satisfies 0.35 ≤ f ≤ 0.55, or 0.40 ≤ f ≤ 0.50. If "f" is at or above the lower limit of the aforementioned range, the curable silicone composition containing the component can achieve favorable hot-melt performance as a whole composition. On the other hand, if "f" is less than or equal to the upper limit of the aforementioned range, the mechanical strength (hardness, and the like) of the cured material obtained is not too low.

In the formula, "g" is a number indicating the percentage of siloxane units in the general formula: R³₂SiO_{2/2}. g is a value that satisfies 0 ≤ g ≤ 0.20, or 0 ≤ g ≤ 0.10. If "g" is less than or equal to the upper limit of the range, the curable silicone composition containing the component can achieve favorable hot-melt performance as a whole composition and a composition with little stickiness at room temperature can be obtained. In the present invention, g may be 0.

In the formula, "h" is a number indicating the percentage of siloxane units in the general formula: R³SiO_{3/2}. h is a value that satisfies 0 ≤ h ≤ 0.20, or 0 ≤ h ≤ 0.10. If "h" is less than or equal to the upper limit of the range, the curable silicone composition containing the component can achieve favorable hot-melt performance as a whole composition and a composition with little stickiness at room temperature can be obtained. In the present invention, h may be 0.

In the above formula, i is a number indicating the ratio of Q units, and should satisfy 0.45 ≤ i ≤ 0.65, or 0.50 ≤ i ≤ 0.65. When "i" is within the numerical value range, the curable silicone composition containing this component can achieve favorable hot-melt performance as a whole composition, and thus a composition can be achieved, which has excellent mechanical strength of a cured material obtained by curing the curable silicone composition, has no stickiness as a whole composition, and has favorable handling workability.

In the formula above, "j" is a number indicating the percentage of units of the general formula: R²O_{1/2}, where the units are a hydroxyl group or alkoxy group bonded to a silicon atom that can be included in the organopolysiloxane resin. "j" is a value that satisfies 0 ≤ j ≤ 0.05, or 0 ≤ j ≤ 0.03. If "j" is at or below the upper limit of the aforementioned range, the curable silicone composition as a whole can achieve a favorable hot-melt performance. Note that in the formula above, the sum of "f", "g", "h", and "i", which is the sum of each siloxane unit, is equal to 1.

Component (A2) is an organopolysiloxane resin having the aforementioned characteristics, and is similar to the aforementioned component (A1) in terms of handling properties. In other words, component (A2) is solid at room temperature (for example, 25°C), and thus, like component (A1), can be used dissolved in the solvent or solvent mixture described above in order to mix with component (B). Thereafter, the solvent can be removed to prepare a curable silicone composition.

### [Removal of Volatile Low Molecular Weight Components in Component (A)]

For component (A1) and the component (A2), volatile low molecular weight components are produced in each production process. Specifically, the volatile low molecular weight components appear as byproducts from polymerizing the organopolysiloxane resins that have a M₄Q structure containing an M unit (R³₃SiO_{1/2}) and a Q unit (SiO_{4/2}). This structure has an effect of significantly reducing the hardness of the cured material obtained by the curable silicone composition. The organopolysiloxane resin of component (A1) and component (A2) is produced by polymerizing the raw material monomers in the presence of an organic solvent that is highly compatible with these components, and removing the organic solvent by drying under reduced pressure, or the like, to obtain a solid organopolysiloxane resin. However, the M₄Q structure has high solubility with the organopolysiloxane resin, and is not easily removed by the drying conditions that remove the organic solvent. It is known that the M₄Q structure can be removed by exposing the organopolysiloxane resin containing these structures to a high temperature of 200°C or higher for a short period of time, but if a curable silicone composition containing the M₄Q structure is molded together with a substrate of a semiconductor or the like, and then exposed to a high temperature to remove the M₄Q structure, the volume of the cured material resulting from the curable silicone composition may decrease and the hardness of the cured material may significantly increase, resulting in changes in dimension, warping, and the like of the molded product. Furthermore, the M₄Q structure also has the effect of imparting adhesiveness to the resulting cured material, essentially increasing the surface tackiness of the cured material. If the intended use of the cured material is as an encapsulant to protect the substrate, especially one side protection, the surface tackiness may need to be reduced as much as possible, and the presence of M₄Q structures can be problematic. Furthermore, if a large amount of M₄Q structure remains in the composition or cured material, a marked increase in hardness may also occur in the adhesive layer or sealing layer for double-sided adhesion, and the elastic modulus may change significantly. Therefore, in order to apply the curable silicone compositions to applications laminated with a substrate of a semiconductor or the like, the M₄Q structure is preferably removed from the organopolysiloxane resin at the point of a raw material prior to a molding process of curing with the curable silicone composition by laminating with a substrate, and, if possible, prior to preparing the curable silicone composition.

Examples of methods of removing the M₄Q structure from the organopolysiloxane resin include methods of obtaining a particulate organopolysiloxane resin in a manufacturing process of the organopolysiloxane resin, which is then dried in an oven or the like to remove the M₄Q structure, methods of removing the structure along with the aforementioned organic solvent in a twin-screw kneader described later, and the like.

More specifically, component (A1) and component (A2) are produced in the presence of organic solvents, and volatile components such as M₄Q structures occur as by-products during the production process. The volatile components can be removed by briefly treating the organopolysiloxane resin, which is the obtained coarse raw material, at a high temperature of approximately 200°C, so the organic solvent and volatile components such as the M₄Q structures and the like can simultaneously be removed from component (A1) and component (A2) using a biaxial mixer set to a temperature of 200°C or higher. From the perspective of efficiently manufacturing the curable hot-melt silicone composition, a step is preferably performed of adding component (B), described later, to component (A2) or a mixture of component (A1) and component (A2) dissolved in an organic solvent, feeding the mixture in a liquid state into a twin-screw extruder set at 200°C or higher, and then removing the M₄Q structure or other volatile components together with the organic solvent. This method enables obtaining a mixture of component (A) and component (B) having hot-melt properties, which can be used for kneading in the remaining components included in the curable silicone composition in a process described later.

### [Mass Ratio of Component (A1) and Component (A2) in Component (A)]

In order for the present composition as a whole to have hot-melt properties, component (A2) or a mixture of component (A1) and component (A2) must be mixed together with component (B), described below, at a prescribed ratio. The ratio of component (A1) and component (A2) may be within a range of 20:80 to 90:10, a range of 35:65 to 90:10, or a range of 50:50 to 90:10. Component (A2) itself does not have curing properties due to not having a curing reactive functional group. However, by using component (A2) in combination with component (A1) in the present composition, it is possible to adjust to a certain degree the storage elastic modulus, loss elastic modulus, and tanδ calculated from the ratio therefrom, thereby achieving an elastic modulus, flexibility, and stress relaxation properties that are suitable for a cured material. Furthermore, a curable hot-melt silicone composition with desired properties can be prepared by combining component (A2) with component (B) without component (A1).

### [Component (B)]

Component (B) is one main component of the present curable silicone composition, is a straight-chain or branched-chain organopolysiloxane, is liquid or has plasticity at 25°C, and has at least two curing reactive functional groups containing carbon-carbon double bonds in each molecule. Such a curing reactive chain organopolysiloxane, when mixed with the solid organopolysiloxane resin of component (A) described above, can exhibit hot-melt properties as an entire composition.

Component (B) must have a curing reactive functional group having a carbon-carbon double bond in a molecule. Such a curing reactive functional group is hydrosilylation reactive, and forms a cured material by a crosslinking reaction with another component. This curing reactive functional group can be an alkenyl group similar to that of component (A1), and in particularly, can be a vinyl group or hexenyl group.

Component (B) is a straight-chain or branched-chain organopolysiloxane that is liquid or has plasticity at 25°C (room temperature), and when mixed with component (A) in a solid state at room temperature, the composition as a whole can exhibit hot-melt properties. A chemical structure of the organopolysiloxane of component (B) may be a straight chain organopolysiloxane, or a branched-chain organopolysiloxane having a small number of branched siloxane units (for example, T units expressed by general formula: R⁴SiO_{3/2} (where R⁴ independently represents a monovalent hydrocarbon group with 1 to 10 carbon atoms) or Q units expressed by SiO_{4/2}), but preferably has
the following structural formula (B1):

R⁴₃SiO(SiR⁴₂O_{2/2})ₖSiR⁴₃

(where each R⁴ independently represents a monovalent hydrocarbon group with 1 to 10 carbon atoms, but at least two of the R⁴s in one molecule represent an alkenyl group, and k represents a number from 20 to 5000).

A linear diorganopolysiloxane having one alkenyl group at each end of the molecular chain is preferred, and vinyl groups are particularly preferable.

In the formula, each R⁴ independently represents a monovalent hydrocarbon group having 1 to 10 carbon atoms. Examples include groups selected from a group consisting of: methyl groups and other alkyl groups; vinyl groups and other alkenyl groups; phenyl groups and other aryl groups; and benzyl groups and other aralkyl groups. Furthermore, at least two of the R⁴ in each molecule are alkenyl groups, and particularly a vinyl group. Furthermore, each R⁴ can be a functional group selected from a group consisting of methyl groups and other alkyl groups with 1 to 10 carbon atoms and vinyl groups, hexenyl groups and other alkenyl groups, and of all R⁴s, at least two in each molecule can be alkenyl groups, and the remaining R⁴ can be methyl groups. Note that from the perspective of a technical effect of the invention, R⁴ is preferably substantially free of phenyl groups and other aryl groups. If a large amount of phenyl groups or other aryl groups are included, the coloring resistance at high temperatures of the cured material obtained from the curable silicone composition may deteriorate. Particularly preferably, a vinyl group or other alkenyl group is provided at each end of the molecular chain, with the remainder of R⁴ being methyl groups.

In the above formula, k is a number between 20 and 5000, 30 and 3000, or 45 and 800. If k is at or above the lower limit of the aforementioned range, a curable silicone composition having little stickiness at room temperature can be obtained. On the other hand, if k is at or below the upper limit of the aforementioned range, the curable silicone composition as a whole can achieve a favorable hot-melt performance.

Herein, in order for the whole composition to exhibit hot-melt properties, the amount of component (B), which is a straight-chain or branched organopolysiloxane, can be within a range of 10 to 100 parts by mass, or within a range of 10 to 70 parts by mass, or within a range of 15 to 50 parts by mass, relative to 100 parts by mass of component (A), which is an organopolysiloxane resin. If the amount of component (B) is within the aforementioned range, the resulting curable silicone composition exhibits favorable hot-melt properties, the mechanical strength of a cured material obtained by curing the curable silicone composition can be increased, and the stickiness of the resulting cured silicone composition at room temperature can be reduced, thereby improving the handling workability of the composition.

### [Component (C)]

Component (C) is an organohydrogenpolysiloxane having at least two silicon atom-bonded hydrogen atoms in one molecule that can be cross-linked with the carbon-carbon double bond in component (A) and component (B) above in the presence of a hydrosilylation reaction catalyst, and is a component that cures the composition.

The structure of the crosslinking agent, organohydrogenpolysiloxane, is not particularly limited and may be linear, branched-chain, cyclic, or resinous. In other words, component (C) may be an organohydrogenpolysiloxane having a hydrogen organosiloxy unit expressed by HR₂SiO_{1/2} (M^{H} unit, where R independently represents a monovalent organic group), or a hydrogen organosiloxy unit expressed by HRSiO_{2/2} (DH unit, where R independently represents a monovalent organic group).

On the other hand, when the curable silicone composition is used in a molding process, since the amount of the curing reactive functional group containing a carbon-carbon double bond in the present composition is small, from the perspective of curing rate, moldability, and curing curability thereof, the organohydrogenpolysiloxane is an organohydrogen polysiloxane resin containing a monoorganosiloxy unit expressed by RSIO_{3/2} (T unit, where R represents a monovalent organic group or a silicon atom-bonded hydrogen atom) or a branched unit of a siloxy unit (Q unit) expressed by SiO_{4/2}, having at least two hydrogen diorganosiloxy units expressed by HR₂SiO_{1/2} (M^{H} unit, where R independently represents a monovalent organic group) in a molecule, and having the M^{H} unit at a molecular terminal.

Particularly suitable organohydrogenpolysiloxanes are expressed by the following average compositional formula (1):

(R⁵₃SiO_{1/2})ₐ(R⁵₂SiO_{2/2})_{b}(R⁵SiO_{3/2})_{c}(SiO_{4/2})_{d}(R²O_{1/2})ₑ (1)

(where R⁵ independently represents an unsubstituted or substituted monovalent hydrocarbon group that does not contain a hydrogen atom or an aliphatic unsaturated bond with 1 to 12 carbon atoms, R6 independently represents an unsubstituted or substituted monovalent hydrocarbon group containing an aliphatic unsaturated bond with 1 to 12 carbon atoms, at least two of all R5s represent hydrogen atoms, and a, b, c, and d represents numbers that satisfy conditions of 0.01 ≤ a ≤ 0.6, 0 ≤ b, 0 ≤ c ≤ 0.9, 0 ≤ d ≤ 0.9, and a + b + c + d = 1 and c + d ≥ 0.2).

Note that the organohydrogenpolysiloxane may optionally have a mass loss ratio relative to pre-exposure of 10% or less after exposure to 100°C for 1 hour under atmospheric pressure.

In the formula above, each R⁵ represents the same or different hydrogen atom or monovalent hydrocarbon group with 1 to 12 carbon atoms without an aliphatic unsaturated carbon bond. However, at least two, and preferably at least three R⁵s in one molecule are hydrogen atoms. The monovalent hydrocarbon group corresponding to R⁵ excluding hydrogen atoms includes, for example: methyl groups and other alkyl groups; phenyl groups and other aryl groups; benzyl groups and other aralkyl groups; other halogenated alkyl groups; and the like. From an industrial standpoint, the monovalent hydrocarbon group expressed by R⁵ can independently be a methyl group or a phenyl group.

In the formula, R⁶ represents a monovalent hydrocarbon group with 1 to 12 carbon atoms without an aliphatic unsaturated carbon bond, and examples include the same groups as the monovalent hydrocarbon group of R⁵ described above. R⁶ can be a group selected from methyl groups and phenyl groups.

In the formula, "a", "b", "c", and "d" are numbers satisfying the following conditions: 0.01 ≤ a ≤ 0.6; 0 ≤ b; 0 ≤ c ≤ 0.9; 0 ≤ d ≤ 0.9; a + b + c + d = 1; and c + d ≥ 0.2. Specific examples include M^{H}MT resins, M^{H}T resins, M^{H}MTQ resins, M^{H}MQ resins, M^{H}DQ resin, M^{H}Q resins, and the like. In the notation of the resin above, M, D, T, and Q represent a M unit, D unit, T unit, and Q unit, respectively, and M^{H} represents an M unit with a hydrogen atom.

In formula (1) above, R² is a hydrogen atom or an alkyl group having 1 to 10 carbon atoms. Examples of alkyl groups in R² include methyl groups and the like. The group R²O_{1/2} containing the R² corresponds to a hydroxyl group or alkoxy group of the organohydrogenpolysiloxane of component (C).

In the formula above, "e" is a number indicating the percentage of units in the general formula: R²O_{1/2}, where the units are a hydroxyl group or alkoxy group bonded to a silicon atom that can be contained in the organopolysiloxane resin. e is a value that satisfies 0 ≤ e ≤ 0.05 and 0 ≤ e ≤ 0.03. Note that in the formula (1) above as described above, the sum of "a", "b", "c", and "d", which is the sum of each siloxane unit, is equal to 1.

Examples of Component (C) include organohydrogenpolysiloxanes expressed by the following average compositional formula (2).

(HR⁷₂SiO_{1/2})_{f}(R⁷₂SiO_{2/2})_{g}(SiO_{4/2})ₕ (2)

In formula (2), R⁷ independently represents an unsubstituted or substituted monovalent hydrocarbon group that does not contain an aliphatic unsaturated bond with 1 to 12 carbon atoms, and f, g, and h are values that satisfy the conditions of 0.01 ≤ f ≤ 0.6, 0 ≤ g ≤ 0.9, 0.2 ≤ h ≤ 0.9, and f + g + h = 1.

Specific examples of the monovalent hydrocarbon group include the same as those indicated as specific examples of the monovalent hydrocarbon group expressed by R⁵ in average compositional formula (1) above. R⁷ can independently be a group selected from methyl groups and phenyl groups.

Furthermore, examples of component (C) include organohydrogenpolysiloxanes expressed by the following average formula (3).

(HR⁸₂SiO_{1/2})ᵢ(R⁸₂SiO_{2/2})ⱼ(R⁹SiO_{3/2})ₖ (3)

In formula (3), R⁸ and R⁹ each independently represent an unsubstituted or substituted monovalent hydrocarbon group that does not contain an aliphatic unsaturated bond with 1 to 12 carbon atoms, 10 mol% or more of all R⁹'s represent aryl groups, and i, j, and k represent values that satisfy the conditions of 0.01 ≤ i ≤ 0.6, 0 ≤ j ≤ 0.9, 0.2 ≤ k ≤ 0.9, and i + j + k = 1.

Specific examples of the monovalent hydrocarbon group include the same as those indicated as specific examples of the monovalent hydrocarbon group expressed by R⁵ in average compositional formula (1) above. R⁹ can independently represent a group selected from methyl groups and phenyl groups, provided that 10 mol% or more of all R⁹ are phenyl groups.

The organohydrogenpolysiloxane expressed by the average compositional formula (2) above and the organohydrogenpolysiloxane expressed by the average compositional formula (3) may be used independently or in combination.

The amount of the organohydrogenpolysiloxane of component (C) in the curable silicone composition is an amount sufficient to cure the curable silicone composition. The amount of hydrogen atoms bonded to a silicon atom in the organohydrogenpolysiloxane of component (C) is an amount where the number of silicon atom-bonded hydrogen atoms per alkenyl group for alkenyl groups bonded to silicon atoms included in the entire curable silicone composition is 0.5 to 20.0, and particularly within a range of 1.0 to 10, with regard to the curing reactive functional groups (such as vinyl groups or other alkenyl groups) containing a carbon-carbon double bond in component (A) and component (B) (hereinafter referred to as "SiH/Vi ratio").

### [Removal of volatile components]

On the other hand, whatever the structure of these organohydrogenpolysiloxanes, the component preferably does not readily volatilize at approximately 100°C under atmospheric pressure, particularly at 1 atm (1013.25 hPa). This is because, in the production process of the curable hot-melt silicone sheet or film described below, in order to obtain a sheet or film that does not contain a void or the like, it is necessary to melt and mix each component of the curable silicone composition and the composition obtained therefrom in a temperature range of 50 to 150°C under reduced pressure. Thus, a sheet or film that does not contain a void or the like can be manufactured by using each component. Although each component is exposed to a prescribed temperature under reduced pressure for a very short period of time, if a large amount of active component volatilizes under these mixing conditions, there is a problem where a composition with the designed properties cannot be obtained. In particular, the amount of organohydrogenpolysiloxane added as a crosslinking agent is small relative to the total mass of the curable silicone composition. Therefore, volatilization of these components can significantly change the properties of the composition (curing properties, physical properties of the cured material, and the like) from an intended value. Therefore, component (C) must not be readily volatile, and specifically, the mass loss ratio with regard to before exposure after exposure to 100°C for one hour under atmospheric pressure is 10 mass% or less, which is preferable depending on the application.

Additionally, the curable silicone composition may contain component (D), a catalyst that promotes the hydrosilylation reaction of component (C) with curable reactive groups that have a carbon-carbon double bond, and/or (E) a filler or pigment.

### [Component (D)]

Component (D) is a catalyst that promotes the hydrosilylation reaction between component (C) and a curing reactive group containing a carbon-carbon double bond. Examples of catalysts include platinum-based catalysts, rhodium-based catalysts, palladium-based catalysts, nickel-based catalysts, iridium-based catalysts, ruthenium-based catalysts, and iron-based catalysts, but a platinum-based catalyst is preferable. Examples of platinum-based catalysts include platinum-based compounds, such as platinum fine powders, platinum black, platinum-supporting silica fine powders, platinum-supporting activated carbon, chloroplatinic acids, alcohol solutions of chloroplatinic acids, olefin complexes of platinum, alkenylsiloxane complexes of platinum, and the like. Alkenylsiloxane complexes of platinum are particularly preferable. Exemplary alkenylsiloxanes include: 1,3-divinyl-1,1,3,3-tetramethyldisiloxane; 1,3,5,7-tetramethyl-1,3,5,7-tetravinylcyclotetrasiloxane; alkenyl siloxanes obtained by substituting a portion of the methyl groups of the alkenylsiloxanes with an ethyl group, a phenyl group, or the like; and alkenylsiloxanes obtained by substituting a portion of the vinyl groups of these alkenylsiloxanes with an allyl group, a hexenyl group, or the like. **The** platinum-alkenyl siloxane complex has favorable stability, so 1,3-divinyl-1,1,3,3-tetramethyldisiloxane is particularly preferable. Furthermore, the stability of the platinum-alkenylsiloxane complex can be improved. Therefore, 1,3-divinyl-1,1,3,3-tetramethyldisiloxane, 1,3-diallyl-1,1,3,3-tetramethyldisiloxane, 1,3-divinyl-1,3-dimethyl-1,3-diphenyldisiloxane, 1,3-divinyl-1,1,3,3-tetraphenyldisiloxane, and 1,3,5,7-tetramethyl-1,3,5,7-tetravinylcyclotetrasiloxane, or other alkenylsiloxane or dimethylsiloxane oligomers or other organosiloxane oligomers are preferably added to the complex, with an alkenylsiloxane particularly preferably added to the complex. **In** addition, from the perspective of improving handling workability and pot life of the composition, these hydrosilylation reaction catalysts may be thermoplastic resin particles containing a hydrosilylation reaction catalyst, which are catalysts dispersed or encapsulated in a thermoplastic resin such as a silicone resin, a polycarbonate resin, an acrylic resin, or the like, and particularly may be thermoplastic resin particles including a hydrosilylation reaction catalyst that contains platinum. It should be noted that as the catalyst for promoting the hydrosilylation reaction, a non-platinum-based metal catalyst such as iron, ruthenium, iron/cobalt, or the like may be used.

At least a portion of component (D) can be (D1) thermoplastic resin fine particles containing a platinum-containing hydrosilylation reaction catalyst, from the perspective of improving the stability during production of the curable silicone composition, handling ease, and pot life of the composition. The thermoplastic fine particles may be either fine particles in which a platinum-based hydrosilylation reaction catalyst is dissolved or dispersed in a thermoplastic resin, or microcapsule fine particles having a structure in which a platinum-based catalyst is contained as a nucleus within a shell of a thermoplastic resin. Examples of platinum catalysts include the alkenylsiloxane complexes of platinum as described above. Furthermore, the thermoplastic resin is not particularly limited so long as the platinum-based catalyst does not substantially permeate at least during production and storage of the curable silicone composition and is not substantially soluble in a main component organopolysiloxane of the curable silicone composition. However, the softening point or glass transition point of the thermoplastic resin is preferably 80°C or higher, and more preferably 120°C or higher. Specifically, a silicone resin, a polysilane resin, an epoxy resin, an acrylic resin, and a methyl cellulose polycarbonate resin can be suitably used. The softening point is the temperature at which a resin begins to flow under its own weight or by its own surface tension, and can be measured by a method of observing pulverized particles under a microscope while increasing the temperature at a constant rate. Furthermore, the glass transition point can be measured by a DSC (differential scanning calorimeter). In the present invention, either the softening point or the glass transition point is preferably 120°C or higher. This is because if the softening point or glass transition point of the thermoplastic resin is less than 120°C, there is a concern that the platinum component will begin to elute during the homogeneous mixing step of the curable silicone composition, which is described later. Furthermore, the average particle size of the thermoplastic fine particles containing the platinum-based catalyst is not limited, but is preferably in the range of 0.1 to 500 µm, and more preferably in the range of 0.3 to 100 µm. This is because preparing thermoplastic resin microparticles containing a platinum-based catalyst with an average particle size that is less than the lower limit of the range above is difficult. On the other hand, dispersibility in the curable silicone composition is reduced if the average particle size exceeds the upper limit of the range above.

The method for preparing the thermoplastic resin microparticles containing the hydrosilylation reaction catalyst containing platinum is not limited, and examples include conventionally known chemical methods such as interfacial polymerization, in-situ polymerization, and the like, and physical and mechanical methods such as coacervation, drying in liquid, and the like. The drying in liquid method and vapor phase drying method using a spray dryer or the like are particularly desirable because obtaining microcapsule fine particles with a narrow particle size distribution is relatively easy. The fine particles obtained by these methods can be used as is, but it is desirable to wash the fine particles with an appropriate cleaning solvent to remove the platinum-based catalyst attached to the surface, in order to obtain a composition with excellent storage stability. Herein, an appropriate cleaning solvent does not dissolve the thermoplastic resin, but has a property of dissolving the platinum-based catalyst. Examples of such cleaning solvents include methyl alcohol, ethyl alcohol, and other alcohols, hexamethyldisiloxane and other low molecular weight organopolysiloxanes, and the like. The ratio of hydrosilylation reaction catalyst to thermoplastic resin is not particularly limited, because the value varies greatly depending on the method for manufacturing a granular product, but the ratio is preferably such that the amount of platinum-based catalyst to thermoplastic resin is 0.01 mass% or more. This is because if the amount of platinum-based catalyst is less than 0.01 mass%, the physical properties of the cured material of the curable silicone composition will be impaired unless a large amount of thermoplastic resin fine particles containing the platinum-based catalyst is included in the curable silicone composition.

The added amount of hydrosilylation-reaction catalyst which is component (D) is preferably an amount such that the metal atoms are within a range of 0.01 to 500 ppm, 0.01 to 100 ppm, or 0.01 to 50 ppm by mass with respect to the entire composition (solid fraction).

Furthermore, a portion or all of component (D) is a hydrosilylation reaction catalyst which does not exhibit activity without irradiation with a high energy beam, but exhibits activity in the composition by irradiation with a high energy beam, or is a so-called high energy beam activation catalyst or photoactivation catalyst. By using such a component (D), the composition as a whole can be cured even at low temperatures triggered by irradiation with a high energy beam, has excellent storage stability, and facilitates reaction control; thus, the properties of excellent handling workability can be achieved.

Examples of high energy beams include UV rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm² to 100 J/cm².

Specific examples of component (D) include trimethyl(methylcyclopentadienyl) platinum (IV), (cyclopentadienyl) trimethyl platinum (IV), (1,2,3,4,5-pentamethyl cyclopentadienyl) trimethyl platinum (IV), (cyclopentadienyl) dimethylethyl platinum (IV), (cyclopentadienyl) dimethylacetyl platinum (IV), (trimethylsilyl cyclopentadienyl) trimethyl platinum (IV), (methoxycarbonyl cyclopentadienyl) trimethyl platinum (IV), (dimethylsilyl cyclopentadienyl) trimethylcyclopentadienyl platinum (IV), trimethyl (acetylacetonato) platinum (IV), trimethyl (3,5-heptanedionate) platinum (IV), trimethyl (methylacetoacetate) platinum (IV), bis(2,4-pentanedionato) platinum (II), bis(2,4-hexanedionato) platinum (II), bis(2,4-heptanedionato) platinum (II), bis(3,5-heptanedionato) platinum (II), bis(1 - phenyl-1,3-butanedionato) platinum (II), bis(1,3-diphenyl-1,3-propanedionato) platinum (II), and bis(hexafluoroacetylacetonato) platinum (II). Of these, (methylcyclopentadienyl) trimethyl platinum (IV) and bis(2,4-pentanedionato) platinum (II) are preferred from the perspective of versatility and ease of acquisition.

The amount of the high energy beam activation catalyst component (D) used is an effective amount and is not particularly limited so long as the amount promotes curing of the composition. Specifically, the amount of metal atoms in the catalyst is within a range of 0.01 to 1000 ppm by mass relative to the entire composition (solid content), and preferably the amount of platinum metal atoms in component (D) is within a range of 0.1 to 500 ppm.

Component (E) is a filler or pigment, which preferably includes a white or colored filler, especially a white or colored inorganic filler, a portion of which may be wavelength converting components such as phosphors, and may also include fine particles with other functions such as conductivity, thermal conductivity, and the like.

The function of the filler or pigment which is component (E) is not particularly limited, but can be expected to make the resulting cured material white or colored, as well as improve the mechanical strength and hardness, and may provide optical functions such as wavelength conversion or the like, or thermal and electrical conductivity. White pigments, black pigments, phosphors, metallic powders, and other functional fillers are examples of component (E), and those that are components that provide white or colored cured materials are particularly preferable. Note that the shape of the filler or pigment which are component (E) is not particularly limited, and may be spherical, spindle-shaped, flat, needle-shaped, amorphous, or the like.

The white pigment is a component that imparts whiteness to the cured material and can enhance light reflectivity. Examples of the white pigment include metal oxides such as titanium oxide, aluminum oxide, zinc oxide, zirconium oxide, magnesium oxide, and the like; hollow fillers such as glass balloons, glass beads, and the like; and additionally, barium sulfate, zinc sulfate, barium titanate, aluminum nitride, boron nitride, and antimony oxide. Titanium oxide has high optical reflectivity and concealing properties, and is therefore preferable. Furthermore, aluminum oxide, zinc oxide, and barium titanate have high optical reflectivity in the UV region, and are therefore preferable examples. The average particle size or shape of the white pigment is not restricted, but the average particle diameter is within a range of 0.05 to 10.0 µm and preferable examples are within a range of 0.1 to 5.0 µm. Furthermore, surface treatment of the white pigment can be performed using a silane coupling agent, silica, aluminum oxide, and the like.

Black pigment is a component that can provide blackness to the cured material and provide light shielding properties to the cured material, but needless to say, the black pigment can also have other functions such as electrical conductivity, as represented by carbon black and graphene. Examples of black pigments more specifically include: carbon-based black pigment such as carbon black, graphite, activated carbon, graphene, and the like; inorganic black pigment such as iron oxide, magnetite, chromium iron oxide, chromium iron nickel oxide, copper chromate, chromite, manganese ferrite, nickel manganese iron oxide, complex metal oxides containing <one or more metals selected from iron, cobalt, copper>, and the like; and organic black pigments such as aniline black, cyanine black, perylene black, and the like.

Phosphor is a component that is blended to convert the emission wavelength from a light source (optical semiconductor element) when the cured material is used as a wavelength conversion material. The phosphor is not particularly limited, and examples thereof include yellow, red, green, and blue light phosphors and the like, which include oxide phosphors, oxynitride phosphors, nitride phosphors, sulfide phosphors, oxysulfide phosphors, and the like and are widely used in light-emitting diodes (LED).

The present composition may also contain inorganic fillers other than those described above, such as reinforcing fillers, thermally conductive fillers, conductive fillers, and the like, represented by silica to improve the mechanical strength of the cured material. Furthermore, component (E) may be surface treated using one or more well-known surface treatment agents such as low molecular weight organosilicon compounds such as silane, silazane, and the like, organosilicon polymers or oligomers, for the purpose of stable blending in the present composition. The amount of surface treatment agent used is not particularly limited, but generally ranges from 0.1 to 2.0 mass% with regard to the total mass of component (E). Furthermore, component (E) may be blended in a masterbatch form by pre-compounding with the other components (A) through (D).

The amount of component (E) is preferably within a range of 0.1 to 100 parts by mass, or within a range of 0.5 to 90 parts by mass, or within a range of 0.5 to 80 parts by mass, or within a range of 1.0 to 50 parts by mass, with regard to 100 parts by mass of the total of components (A) to (D). If the amount of component (E) added is less than the aforementioned range, a problem of insufficient coloring effect may occur, and if the amount is higher than the aforementioned range, a problem of excessively high melt viscosity of the obtained hot-melt composition may occur, while at the same time, when produced by the method described below, it may be difficult to mix the entire composition evenly, the manufacturing equipment will readily wear out, and color fading may occur in the obtained composition or the target color may not be obtained.

In addition to components (A) to (E) above, the curable silicone composition may further contain a cure retarding agent (E), from the perspective of practicality and further enhancing the storage stability.

The structure of the cure retarding agent is not particularly limited, but the boiling point is preferably 200°C or higher under atmospheric pressure. This is because if a compound with a low boiling point is used as a delayed curing agent when melting and mixing raw materials under reduced pressure in a production of the curable silicone composition sheet described below, a portion or all of the cure retarding agent may volatilize during the manufacturing process composition, and thus a targeted cure delaying effect for the curable silicone composition may not be achieved.

The cure retarding agent is not particularly limited, and examples include: 2-methyl-3-butyne-2-ol, 3,5-dimethyl-1-hexyne-3-ol, 2-phenyl-3-butyne-2-ol, 1-ethynyl-1-cyclohexanol, and other alkyne alcohols; 3-methyl-3-pentene-1-yne, 3,5-dimethyl-3-hexene-1-yne, and other enyne compounds; tetramethyltetravinylcyclotetrasiloxane, tetramethyltetrahexenylcyclotetrasiloxane, and other alkenyl group-containing low molecular weight siloxanes; and methyl tris(1,1-dimethyl propynyloxy)silane, vinyl tris(1,1-dimethyl propynyloxy)silane, and other alkynyloxysilanes. Of these, the use of compounds with a boiling point of 200°C or higher under atmospheric pressure (for example, vinyl-tris(1,1-dimethylpropynyloxy)silane or the like) is particularly preferable. The amount of the cure retarding agent in the curable silicone composition is not particularly limited, but can be within a range of 1 to 10,000 ppm in mass units, with regard to the composition.

### [Adhesion-imparting agent]

The composition may contain a well-known adhesion imparting agent as another optional component so long as an object of the present invention is not impaired. The adhesion imparting agent is not particularly limited so long as being a component that enhances the adhesion to the substrate of the cured material made by curing the present composition, and suitable examples of components suggested by the present applicant in International Patent Application (PCT/JP2020/12027) include silane compounds such as 3-glycidoxypropyltrimethoxysilane and the like; organosiloxane oligomers; alkyl silicates; reactive mixtures of epoxy group-containing organoalkoxysilane and amino group-containing organoalkoxysilane disclosed in Japanese Examined Patent Publication S52-8854 and Japanese Unexamined Patent Application H10-195085; carbasilatrane derivatives having a silicon atom-bonded alkoxy group and a silicon atom-bonded alkenyl group in each molecule; silatrane derivatives having an alkoxysilyl group-containing organic group; and disilyakane compounds such as 1,6-bis(trimethoxysilyl)hexane, and the like. Combinations of 2 or more of these components can be used. Furthermore, while not limited thereto, the amount of the adhesion imparting agent used can be within a range of 0.01 to 10 parts by mass with respect to a total of 100 parts by mass of the present composition.

### [Other additives]

In addition to the aforementioned components, materials well-known in the art as additives that may be used in a silicone composition may be added to the curable hot-melt silicone composition. For example, the composition may contain, as other optional components, heat resistance agents such as iron oxide (red iron oxide), cerium oxide, cerium dimethyl silanolate, fatty acid cerium salt, cerium hydroxide, zirconium compound, and the like; and in addition, dyes, pigments other than white, flame retardancy imparting agents, and the like.

### [Cured resin material]

The cured resin material of the present invention may be obtained by curing the aforementioned curable silicone composition by one or more curing means selected from heating and high energy beam radiation.

The heating temperature is preferably within a range of 50°C to 180°C, and more preferably 80°C to 160°C. The heating time is from 30 minutes to 5 hours, more preferably from 30 minutes to 2 hours.

Examples of high energy beams include UV rays, gamma rays, X-rays, alpha rays, electron beams, and the like. In particular, examples include ultraviolet rays, X-rays, and electron beams irradiated from a commercially available electron beam irradiating device. Of these, ultraviolet rays are preferable from the perspective of efficiency of catalyst activation, and ultraviolet rays within a wavelength range of 280 to 380 nm are preferable from the perspective of industrial use. Furthermore, the irradiation dose varies depending on the type of high energy beam activated catalyst, but in the case of ultraviolet light, the integrated irradiation dose at a wavelength of 365 nm is preferably within a range of 100 mJ/cm² to 100 J/cm².

### [Sheet]

The sheet-like cured resin material of the present invention may be formed by forming the curable silicone composition into a sheet and curing. For example, a sheet containing the curable silicone composition having an average thickness of 10 to 1,000 µm has hot-melt properties and has heat curability under high temperatures. Therefore, the sheet or film has excellent handling workability and melting properties, and is particularly advantageous for use in compression molding or the like. In this case, the composition containing all of components (A) to (F), including component (F), can be molded into a sheet.

Such a sheet-like curable silicone composition can be formed into a uniform mixture of all components using a uniaxial or biaxial continuous kneader, and then the mixture can be passed through two rollers or the like and molded into a sheet or film of a prescribed thickness. Furthermore, once the granular curable hot-melt silicone composition described below is obtained, and after adding component (F) if necessary, the mixture may be kneaded in a kneader to make homogeneous and then passed through a molding machine such as two rollers or the like to manufacture a sheet or film adjusted to a prescribed thickness.

The sheet-like silicone composition may be manufactured using fine organopolysiloxane resin particles as a raw material (Method A) or may be manufactured using a hot-melt solid fraction, which is obtained by dispersing an organopolysiloxane resin that is a solid at room temperature and optionally a chain diorganopolysiloxane in an organic solvent and then removing the organic solvent, as a raw material (hot-melt bulk method) (Method B).

Specifically, the former (method A) includes the following steps:
Step 1: A step of mixing organopolysiloxane resin particles, curing agent, and optionally, in some cases, functional fillers;
Step 2: A step of kneading the mixture obtained in Step 1 while heating and melting at a temperature of 120°C or lower;
Step 3: A step where the mixture after heating and melting and mixing obtained in Step 2 is laminated between two films, each having at least one release surface, to form a laminate body; and
Step 4: A step of stretching the mixture in the laminate body obtained in Step 3 between rollers to form a curable hot-melt silicone sheet having a specific film thickness.

On the other hand, the latter method (Method B) includes the following steps of:
Step 1: A step of obtaining a hot-melt solid by removing an organic solvent at a temperature of 150°C or higher from a solution in which an organopolysiloxane resin in a solid state at room temperature and optionally a diorganopolysiloxane in a chain state are dispersed or dissolved in an organic solvent;
Step 2: A step where after adding all the curing agents to the hot-meltable solids obtained in Step 1, the mixture is kneaded while heating and melting at a temperature below 120°C;
Step 3: A step wherein the mixture after heating and melting obtained in Step 2 is laminated between two films, each having at least one release surface, to form a laminate body; and
Step 4: A step of stretching the mixture in the laminate body obtained in Step 3 between rollers to form a curable hot-melt silicone sheet having a specific film thickness.

Furthermore, Step 3 and Step 4 can be continuous and integrated, and for example, the heated and melted mixture obtained in Step 2 is laminated by being discharged or applied between films having at least one release surface directly under the rollers, and at the same time, the film may be stretched and molded to a specific thickness by adjusting the gap between the rollers. Thus, a manufacturing method having a process in which Step 3 and Step 4 are substantially integrated is also included within the scope of the above manufacturing method.

In other words, Steps 3 and 4 may be carried out in a continuous and integrated manner, for example, a process in which the mixture obtained in Step 2 is discharged or applied between two release films to sandwich the aforementioned mixture between the two release films, such as between two long release films, and a process in which a laminated body comprising the two release films and the aforementioned mixture interposed therebetween is continuously passed between rolls to stretch and form the mixture between the release films to obtain a desired laminated body. Such a method in which Step 3 and Step 4 are performed in an integrated manner is also included in the above-described manufacturing method.

In addition, in the above Step 3 for method A or method B, the process of laminating the mixture after heating and melting between the films is not particularly limited, and may be a process in which:
(i) the mixture after heating and melting from Step 2 is discharged or applied onto a first release film having a release surface, and then a second release film is brought into contact with the surface of the mixture opposite to the surface in contact with the first release film, such that the mixture after heating and melting is interposed, or in other words sandwiched, between the first and second release films; or in which
(ii) the mixture after heating and melting in Step 2 is discharged or applied between the first release film and the second release film having a peeling surface, such that the mixture after heating and melting is interposed between the two release films. An example of (ii) can be a method of bringing the first and second release films into close proximity by suitable means, such as two rolls, and discharging or coating the mixture from Step 2 at the point where the two release films are brought into close proximity, thereby placing the mixture in the gap between the two release films at the same time or approximately at the same time. Steps 3 and 4 above may be continuous processes.

Note that with respect to the manufacturing method thereof, the present applicants have proposed an entire process for manufacturing a curable silicone sheet and a manufacturing apparatus used therewith in Japanese Patent Application 2019-167832 and Japanese Patent Application 2019-167833, as well as priority claim applications thereof (including international patent applications). The present invention can use this method and manufacturing apparatus for making a sheet or a film of the curable hot-melt silicone composition.

The viscosity of the curable silicone composition tends to decrease rapidly with an increase in temperature at high temperature and high pressure (in other words, for example, in the manufacturing process of the laminate body described above), and can be used as a useful melt viscosity value for handling the curable silicone composition, the value measured under high temperature and high pressure similar to the conditions when the curable silicone composition is actually used. Therefore, the melt viscosity of the curable silicone composition can be measured under high pressure using a Koka-type flow tester (manufactured by the Shimadzu Corporation) rather than measured with a rotational viscometer such as a rheometer. Specifically, the curable silicone composition can have a melt viscosity at 100°C of 1 to 500 Pa·s, or 1 to 300 Pa·s, as measured using a Koka-type flow tester. This is because when the melt viscosity is within this range, the curable silicone composition exhibits favorable gap filling properties when in a hot melt state.

### [Conductive pillar member]

The conductive pillar member is a pillar having conductivity, and is preferably a metal pillar such as gold, silver, copper, nickel, or the like, and more preferably a copper pillar. The conductive pillar member is preferably a conductive pillar having a minor axis length of 50 to 500 µm and a major axis length of 50 to 500 µm, and more preferably has a minor axis length of 100 to 400 µm and a major axis length of 100 to 400 µm. Moreover, the conductive pillar member is preferably cylindrical with a diameter of 50 to 500 µm and a height of 50 to 2000 µm, and more preferably has a diameter of 100 to 400 µm and a height of 100 to 1000 µm.

In one embodiment, the sheet-like cured resin material of the conductive pillar module precursor for semiconductor manufacturing is preferably a silicone cured material, and the conductive pillar member is preferably a conductive pillar having a minor axis length of 50 to 500 µm and a major axis length of 50 to 500 µm.

In one embodiment, the conductive pillar module precursor for semiconductor manufacturing is a silicone cured material obtained by curing a sheet-like cured resin material by a hydrosilylation reaction, and the conductive pillar member is preferably a cylindrical copper pillar having a diameter of 50 to 500 µm and a height of 50 to 2000 µm.

### [Conductive pillar module for semiconductor manufacturing]

The conductive pillar module for semiconductor manufacturing of the present invention has a structure where the conductive pillar member is supported by a sheet-like cured resin material, and the conductive pillar member is exposed from both sides of the sheet-shaped cured resin material.

FIG. 2 depicts an embodiment of the conductive pillar module for semiconductor manufacturing of the present invention. The conductive pillar module for semiconductor manufacturing of the present invention has a structure in which a plurality of conductive pillar members (2) are supported on a sheet-like cured resin material (1'), and the conductive pillar members are exposed on both sides of the sheet-like cured resin material.

### [Semiconductor or semiconductor precursor]

The semiconductor or semiconductor precursor of the present invention has a structure where at least a portion of the conductive pillar members of the conductive pillar module for semiconductor manufacturing of the present invention is soldered onto a substrate, and the conductive pillar exposed from the opposite surface of the sheet-like cured resin material is bonded to a semiconductor chip directly or via a conductive layer (redistribution layer).

FIG. 3 depicts an embodiment of the semiconductor or semiconductor precursor of the present invention. The semiconductor or semiconductor precursor of the present invention has a structure where at least a portion of the conductive pillar members (2) of the conductive pillar module for semiconductor manufacturing (A) of the present invention is soldered onto a substrate (3), and the conductive pillar (2) exposed from the opposite surface of the sheet-like cured resin material (1') is bonded to a semiconductor chip (4) directly or via a conductive layer (redistribution layer) (5).

Specifically, the substrate may be a substrate commonly used in this technical field, such as a rigid substrate, a flexible substrate, a rigid-flex substrate, or a metal-based substrate. Furthermore, the redistribution layer may be made of a material commonly used in this technical field, and may be made of copper wires provided in an insulating layer, such as polyimide, polybenzoxazole, benzocyclobutene, or the like.

The semiconductor chip and redistribution layer may use materials commonly used in this technical field.

In one embodiment, the semiconductor or semiconductor precursor of the present invention preferably has a structure in which the gaps between the substrate, the semiconductor chip and the conductive pillar members are filled with a mold underfill material.

FIG. 4 depicts an embodiment of the semiconductor or semiconductor precursor of the present invention. The semiconductor or semiconductor precursor of the present invention provides a structure in which the gaps between the substrate (3), the semiconductor chip (4) and the conductive pillar members (A) are filled with a mold underfill material (6).

The mold underfill material may be a material commonly used in this technical field, such as a silicone resin, epoxy resin, and the like.

### [Method of producing semiconductor or semiconductor precursor]

The method for manufacturing a semiconductor or a semiconductor precursor of the present invention includes a step of bonding a conductive pillar member exposed from the conductive pillar module precursor for semiconductor manufacturing of the present invention to a semiconductor chip or substrate.

[Method for manufacturing conductive pillar module precursor for semiconductor manufacturing]

The method of manufacturing a conductive pillar module precursor for semiconductor manufacturing of the present invention includes the following steps (I) to (IV):
Step (I): a step of providing a conductive pillar member on a mold member;
Step (II): a step of providing at least one curable resin composition and, optionally, a release liner on the conductive pillar member;
Step (III): a step of curing the curable resin composition into a sheet shape by one or more curing means selected from heating and high energy beam radiation; and
Step (IV): a step of separating the conductive pillar module precursor for semiconductor manufacturing from the mold member, optionally after removing the release liner.

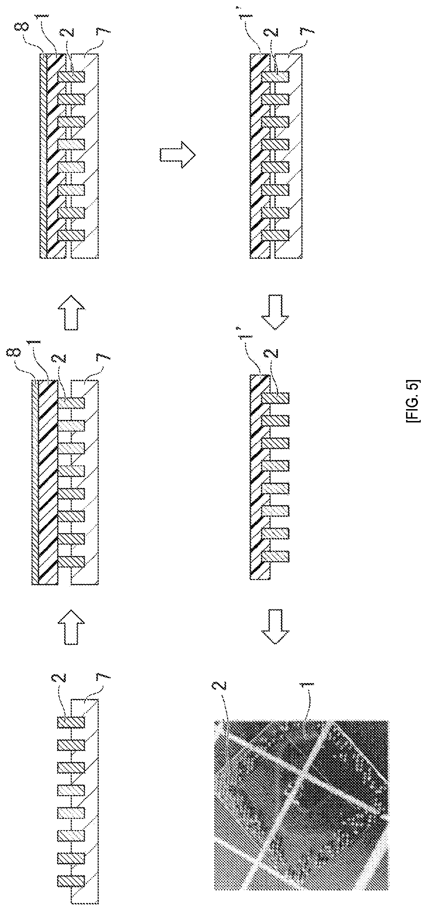

FIG. 5 depicts an embodiment of the method for manufacturing a conductive pillar module precursor for semiconductor manufacturing of the present invention. The method includes a step of first providing a conductive pillar member (2) on a mold member (7) (Step (I)), then providing a curable resin composition (1) and, optionally, a release liner (8) on the conductive pillar member (2) (Step (II)), and further performing lamination while applying pressure in a range of 0.01 to 2.00 MPa under heating in a range of 50 to 150°C, subsequently or simultaneously curing the curable resin composition (1) into a sheet shape (1') by one or more curing means selected from heating and with high-energy beam radiation (step (III)), and then removing the release liner and separating the conductive pillar module precursor for semiconductor manufacturing from the mold member (7) (Step (IV)). The photograph depicted in FIG. 5 is a top view of the conductive pillar module precursor for semiconductor manufacturing of the present invention.

In step (II) or (III), a release liner may be laminated on the surface of the curable resin composition, and the surface of the curable resin composition may be made uniform. Finally, the release liner is removed from the surface of the semiconductor manufacturing pillar module precursor.

Optionally, in any step, the semiconductor manufacturing pillar module precursor may be diced into pieces.

The curable resin composition may be the curable silicone composition described above.

In one embodiment, Step (II) is preferably a step where the curable resin composition used is a sheet of the curable resin composition having heat-melting properties, the sheet of the curable resin composition is placed on a conductive pillar member, and then the sheet of the curable resin composition is heated and melted to support at least a portion of the conductive pillar inside the sheet of the curable resin composition.

The sheet of the curable resin composition may be formed from a laminate of the curable silicone composition.

### [Laminate body]

The laminate body of the curable silicone composition may be a laminate body having a structure in which a sheet-like material made of the aforementioned curable silicone composition is interposed between two film-like substrates each having a release layer. The film-like substrates equipped with a release layer (generally referred to as a release film) can be peeled off from the sheet-like material made of a curable silicone composition when the sheet-like material is used. The laminate body is also referred to as a releasable laminate body below.

Although there are no particular limitations on the method of manufacturing the peelable laminate body, a method including the following steps can be mentioned as an example:
Step 1: step of mixing the structural components of the curable silicone composition described above;
Step 2: a step of kneading the mixture obtained in Step 1 while heating and melting;
Step 3: a step of laminating the mixture heated and melted in Step 2 between two release films with at least one release surface, so that the mixture is in contact with the release surfaces to form a laminate body; and
Step 4: a step of pressing the laminate body obtained in step 3 between rollers to roll out the mixture interposed between the two release films to form a curable silicone composition sheet having a specific thickness.

Furthermore, rollers with a cooling or temperature adjusting function may be optionally used in Step 4. Furthermore, after Step 4, a step of cutting the resulting laminate body containing the curable silicone composition sheet may be added.

Note that the thickness of the release film is not particularly limited, and therefore, in addition to those generally referred to as a film, those referred to as a sheet are also included. However, in the present specification, it is referred to as a release film regardless of the thickness thereof.

The temperature of the mixing process in Step 1 above is not particularly limited, but heating may be performed as necessary to ensure that each component is sufficiently mixed. For example, the heating temperature can be 50°C or higher.

A sheet containing the curable hot-melt silicone composition is obtained by removing the release film from the peelable laminate body of the present invention. The sheet may have a thickness of 10 to 1000 µm and may be flat. Flat means that the thickness of the resulting sheet or film is within the range of ±100 µm or less, preferably within the range of ±50 µm or less, and more preferably within the range of ±30 µm or less.

The type of material of the substrate for the release film that constitutes the peelable laminate body is not limited, but polyester film, polyolefin film, polycarbonate film, or acrylic film, for example, can be used as appropriate. The sheet substrate can be non-porous. A release film is a film having a release layer formed by treating one or both sides of a film made of such a material to give it release properties, and such treatments are known in the art.

The release layer is a releasable layer applied to the surface of a release film. Moreover, the release layer is a structure that allows a sheet or film made of a curable silicone composition to be easily released from a film-like substrate, and is sometimes referred to as a release liner, separator, mold release layer or release coating layer. Suitably, the release layer can be formed as a release layer with release coating capability such as with a silicone release agent, fluorine release agent, alkyd release agent, or fluorosilicone release agent. Alternatively, the surface of the film substrate may be physically formed with minute irregularities to reduce adhesion to the curable silicone composition, or the substrate may be made of a material that adheres only with difficulty to the curable hot-melt silicone composition of the present invention or to a layer comprising a cured material thereof. In particular, in the laminated body of the present invention, a release layer obtained by curing a fluorosilicone based release agent is preferably used as the release layer.

The laminate body described above can be used, for example, by peeling off one of the two release films comprising the laminate body, applying the uncured sheet containing the curable silicone composition that is not in contact with the release film to the adherend, and then peeling off the uncured sheet or film-like member from the other film-like substrate, that is, the release film.

The curable silicone composition is a low-flow or no-flow solid at 25°C, and can be handled at room temperature in granular, pellet or sheet form. Here, non-flow properties means that the curable silicone composition does not deform and/or flow in the absence of external force, and suitably, the curable silicone composition does not deform and/or flow at 25°C and in the absence of external force when molded into pellets or tablets. Such non-flow properties can be assessed, for example, by placing the molded composition on a hot plate at 25°C and applying no external force or a certain amount of weight to the composition, and making sure substantial deformation and/or flow of the composition does not occur. If the composition is non-flowable at 25°C, handling even in an uncured state is simple because shape retention of the composition is favorable at that temperature and the surface adhesion thereof is low.

Additionally, the softening point of the curable silicone composition is preferably 100°C or lower. Such a softening point means the temperature at which the deformation amount of the composition in the height direction is 1 mm or more when the composition is pressed for 10 seconds from above with a 100 gram load at a height of 22 mm on a hot plate and the deformation of the composition is measured after the load is removed.

In one embodiment, the method for manufacturing a conductive pillar module precursor for semiconductor manufacturing of the present invention has a Step (II) where the curable resin composition used is preferably a hydrosilylation reaction-curable silicone sheet having heat-melting properties, and the hydrosilylation reaction-curable silicone sheet is placed on a conductive pillar member, and then the hydrosilylation reaction-curable silicone sheet is heated and melted to support at least a portion of the conductive pillar member inside the sheet of the curable resin composition; and
Step (III) is preferably a step of curing the hydrosilylation-curable silicone sheet in a sheet form by one or more curing means selected from the group consisting of heating and high energy beam radiation.

The heat-melting temperature of the hydrosilylation-curable silicone sheet is preferably in a range of 50°C to 150°C, or 50 to 120°C.

The heating temperature and time, as well as the type and dose of high energy beam radiation for curing the hydrosilylation reactive curable silicone sheet, are as described above. Preferably, a high-energy beam is radiated, and then the film is heated.

In one embodiment, the method for manufacturing a conductive pillar module precursor for semiconductor manufacturing of the present invention preferably further includes, after the aforementioned step (IV), a step of bonding the optionally exposed conductive pillar member to a semiconductor chip or substrate, and then scraping off at least one surface of the sheet-like cured resin material to expose the conductive pillar on both surfaces of the sheet-like cured resin.

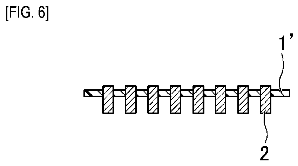

FIG. 6 depicts an embodiment of a conductive pillar module precursor manufactured by the method for manufacturing a conductive pillar module precursor for semiconductor manufacturing of the present invention. A structure is provided in which a plurality of conductive pillar members (2) are supported on a sheet-like cured resin material (1'), and the conductive pillar members are exposed on both sides of the sheet-like cured resin material.

Furthermore, in another embodiment, the method of manufacturing a conductive pillar module precursor for semiconductor manufacturing of the present invention includes the following steps (I') to (V'):
Step (I'): a step of providing a conductive pillar member on a first mold member;
Step (II'): a step of placing a second mold member on the conductive pillar member;
Step (III'): a step of filling gaps between the conductive pillar member, the first molding member, and the second molding member with a curable resin composition;
Step (IV'): a step of curing the curable resin composition into a sheet shape by one or more curing means selected from heating and high energy beam radiation; and
Step (V'): a step of separating the first molding member and the second molding member from the conductive pillar module precursor for semiconductor manufacturing.

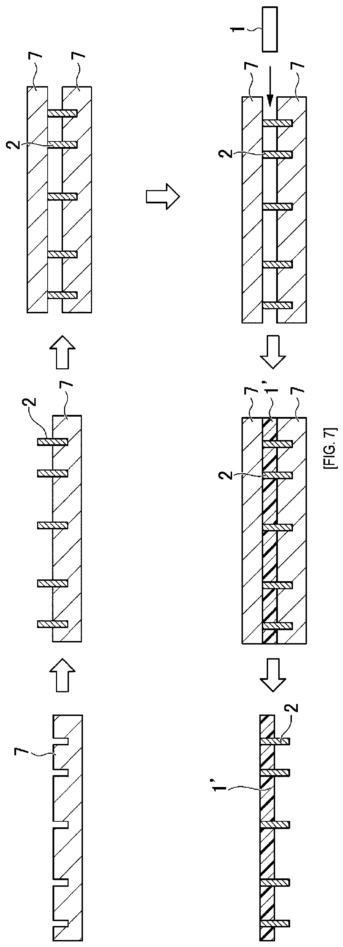

FIG. 7 depicts an embodiment of the method for manufacturing a conductive pillar module precursor for semiconductor manufacturing of the present invention. The method includes first providing a conductive pillar member (2) on a first mold member (7) (Step (I')); then providing a second mold member (7) on the conductive pillar member (2) (Step (II')); filling the gaps between the conductive pillar member (2), the first mold member (7), and the second mold member (7) with a curable resin composition (1) (Step (III')), curing the curable resin composition (1) into a sheet shape (1') by one or more curing means selected from heating and radiation with high-energy beams (Step (IV')); and finally separating the first and second mold members (7) from the conductive pillar module precursor for semiconductor manufacturing (A) (Step (V')).

In addition to storage stability, the curable resin composition or sheet thereof has hot-melt properties that provide excellent flow properties and low viscosity at high temperature. Therefore, the composition or sheet can be softened or fluidized by heating prior to final curing, for example, to form an adhesive surface with an adherend by filling protrusions and recesses or gaps without a void, even if there are minute irregularities on the adhesive surface of the adherend.

### [Method of producing semiconductor or semiconductor precursor]

The method of manufacturing a semiconductor or a semiconductor precursor of the present invention includes the following steps (L1) to (L5):
Step (L1): a step of bonding the conductive pillar module precursor for semiconductor manufacturing of the present invention to a carrier member;
Step (L2): a step of bonding a semiconductor chip to a conductive pillar member on one side of the conductive pillar module precursor for semiconductor manufacturing, with the conductive pillar member being exposed from the sheet-like cured resin material;
Step (L3): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4): a step of soldering the conductive pillar member exposed in step (L3) to a substrate; and
Step (L5): a step of filling the gaps between the substrate, the semiconductor chip, and the conductive pillar member with a mold underfill material.

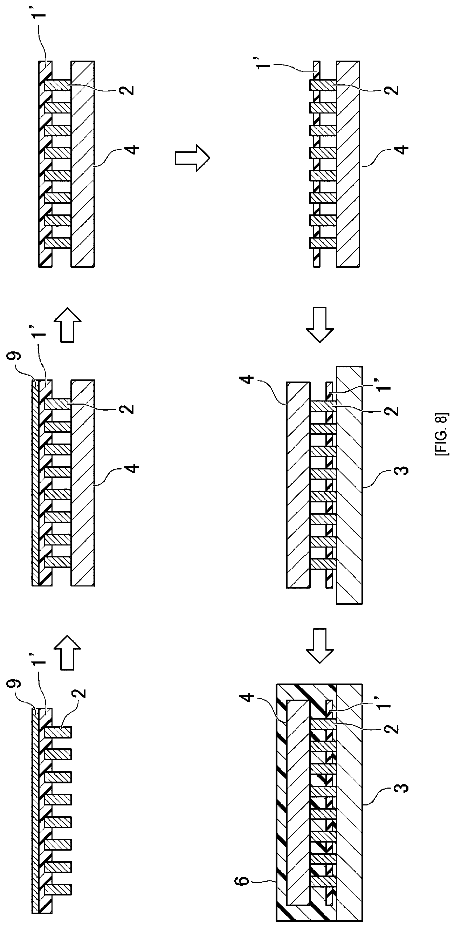

FIG. 8 depicts an embodiment of a method for manufacturing a semiconductor or semiconductor precursor of the present invention by flip chip packaging. First, the conductive pillar module precursor (A) for semiconductor manufacturing of the present invention is closely adhered to a carrier member (9) (Step (L1)); then, the conductive pillar member (2) on one side exposed from the sheet-like cured resin material (1') of the conductive pillar module precursor for semiconductor manufacturing (A) is bonded to a semiconductor chip (4), preferably by thermocompression bonding (Step (L2)); furthermore, after removing the carrier member (9) from the conductive pillar module precursor for semiconductor manufacturing (A), at least one side of the sheet-like cured resin material (1') is scraped off to expose the conductive pillar member (2) on the surface of the sheet-like cured resin material (1') (Step (L3)); in addition, the conductive pillar member (2) exposed in Step (L3) is soldered to the substrate (3) (Step (L4)); and finally, the gaps between the substrate (3), the semiconductor chip (4), and the conductive pillar member (2) are filled with a mold underfill material (6) (Step (L5)).

Furthermore, another embodiment of the method of manufacturing a semiconductor or a semiconductor precursor of the present invention includes the following steps (L1') to (L5'):
Step (L1'): a step of bonding the conductive pillar module precursor for semiconductor manufacturing of the present invention to a carrier member;
Step (L2'): a step of bonding to the substrate by soldering the conductive pillar member on one side of the conductive pillar module precursor for semiconductor manufacturing, the conductive pillar member being exposed from the sheet-like cured resin material;
Step (L3'): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4'): a step of bonding the conductive pillar exposed in step (L3') to a semiconductor chip, either directly or via a conductive layer (redistribution layer); and
Step (L5'): a step of filling the gaps between the substrate, the semiconductor chip, and the conductive pillar with a mold underfill material.

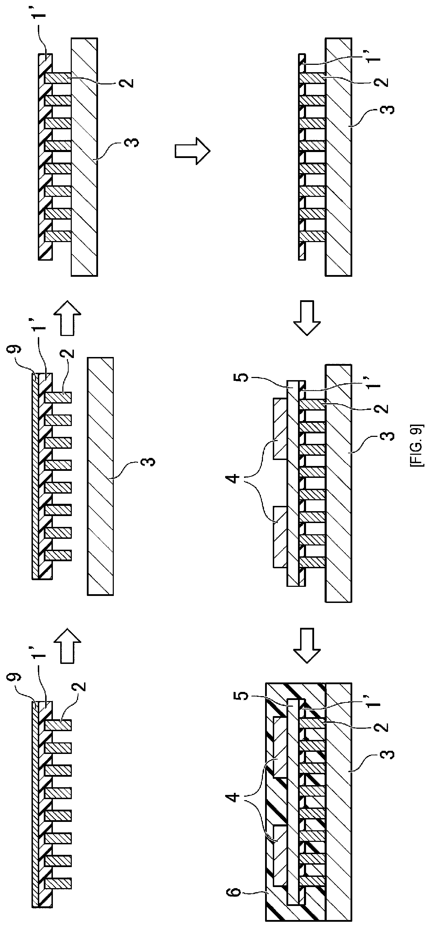

FIG. 9 depicts an embodiment of a method for manufacturing a semiconductor or semiconductor precursor of the present invention with a chip-last package using an RDL (redistribution layer). First, the conductive pillar module precursor for semiconductor manufacturing (A) of the present invention is bonded to a carrier member (9) (Step (L1')); the conductive pillar member (2) on one side exposed from the sheet-like resin cured material (1') of the conductive pillar module precursor for semiconductor manufacturing (A) is bonded to the substrate (3) by reflow soldering (Step (L2')); the carrier member (9) is removed from the conductive pillar module precursor for semiconductor manufacturing (A), and then at least one surface of the sheet-like cured resin material (1') is scraped off so that conductive pillar (2) is exposed on the surface of the sheet-like cured resin material (1') (Step (L3')); a conductive layer (redistribution layer) (5) is bonded onto the conductive pillar (2) exposed in Step (L3') and a semiconductor chip (4) is bonded thereon (Step (L4')), and finally the gaps between the substrate (3), the semiconductor chip (4), and the conductive pillar (2) are filled with a mold underfill material (6) (Step (L5')).

The present invention will be described below by way of examples; however, the present invention is not limited thereto.

### EXAMPLES

The method for manufacturing a conductive pillar module precursor for semiconductor manufacturing of the present invention and the properties thereof will be described below in detail with reference to examples. Note that in the following description, Me, Vi, and Ph in the average unit formula represent methyl, vinyl, and phenyl groups, respectively. In addition, the adhesive properties and precursor reliability properties of the conductive pillar module precursor for semiconductor manufacturing of each example were measured by the following methods. The results are shown in Table 1.

### [Adhesion properties of film sample]

A 200 µm thick silicone film, a 160 µm thick PET (polyethylene terephthalate) film, and a 150 µm thick polyimide film were each cut to 1 cm x 1 cm and sandwiched between two copper plates to form a laminate structure containing the three layers of copper, sample film, and copper. The PET film and the polyimide film were crushed at a pressure of 30 MPa in a hot press set to temperatures of 100°C and 120°C, respectively, to form an integrated product. After lamination, the silicone film was radiated with ultraviolet light having a wavelength of 365 nm so that the radiation dose was 10 J/cm², and then cured at 120°C for 1 hour. The obtained adhesion test pieces were subjected to an adhesion test by a tensile test to measure the adhesive strength. In addition, in order to confirm the reliability of the adhesive properties, the obtained adhesive test samples were aged for 336 hours in a chamber at 85°C and 85% humidity, and then subjected to 500 cycles of 40°C x 30 minutes ⇔ 125°C x 30 minutes, after which the adhesive strength was measured again.

### [Thermal stability of conductive pillar module precursors for semiconductor manufacturing]

A conductive pillar made of copper was placed on each sample film using a chip transfer device. The silicone film was transferred at room temperature, but the PET and polyimide films were transferred while the stage was heated to 100°C, particularly 120°C. After this process, only the structure containing the silicone film and the conductive pillars was irradiated with ultraviolet light having a wavelength of 365 nm so as to provide a radiation dose of 10 J/cm², and then exposed to 120°C for 1 hour to cure the silicone film. The obtained structure was placed in an oven set to 250°C for 30 seconds, and then the structure was visually inspected for warping and movement of the conductive pillars.

### [Softening Point]

The curable sample film composition (applicable only to the silicone film) was molded into a cylindrical pellet of φ14 mm × 22 mm. The pellet was placed on a hot plate set at 25°C to 100°C and continuously pressed from above for 10 seconds by a load of 100 grams, and after the load was removed, the amount of deformation of the pellet was measured. The temperature at which the deformation amount in the height direction was 1 mm or more was defined as the softening point.

### [Curing properties]

The curable sample film composition (corresponding to only the silicone film) was vulcanized for 600 seconds at the molding temperature (160°C) using a curastometer (PREMIERMDR manufactured by Alpha Technologies) in accordance with a method specified in JIS K 6300-2:2001, "Unvulcanized Rubber - Physical Properties - Part 2: Determination of Vulcanization Characteristics Using a Vibratory Vulcanization Tester" to measure the curing properties. Note that for the measurement, a mass of the curable hot-melt silicone composition was weighed out at approximately 5 g, sandwiched between 50 µm-thick PET films, then placed on a lower die, after which measurement was initiated once the upper die had closed. Note that the measurements were made using an R-type die for rubber, with an amplitude angle of 0.53°, a vibration frequency of 100 times/minute, and a maximum torque range of 230 kgf·cm. As a result of the measurement, the time (ts-1) required to exceed a torque value of 1 dNm was read in units of seconds.

### [Silicone film production]

Mixtures having the hot-melt properties of organopolysiloxane resin and straight-chain organopolysiloxanes were prepared by the methods indicated in following Reference Example 1.

### [Reference Example 1: Hot-melt mixture 1]

2.40 kg of an organopolysiloxane resin (vinyl group content = 1.9 mass%) that was a white solid at 25°C and is expressed by the average unit formula:

(Me₂ViSiO_{1/2})_{0.05}(Me₃SiO_{1/2})_{0.39}(SiO_{4/2})_{0.56}(HO_{1/2})_{0.02}

4.46 kg of an organopolysiloxane resin (vinyl group content = 0 mass%) that was a white solid at 25°C and is expressed by the average unit formula:

(Me₃SiO_{1/2})_{0.44}(SiO_{4/2})_{0.56}(HO_{1/2})_{0.02}

and
2.69 kg of dimethylpolysiloxane terminated at both molecular chain ends with dimethylvinylsiloxy groups (vinyl group content = 0.09 mass%) and expressed by the formula

ViMe₂SiO(Me₂SiO)₈₀₀SiViMe₂

were dissolved in 4.00 kg of xylene in a pail using a three-one motor.

The resulting solution was fed into a twin-screw extruder with the maximum attainable temperature set at 230°C. The xylene and low molecular weight organopolysiloxane components were removed under a vacuum of -0.08 MPa, resulting in a hot-melt mixture 1. The mixture 1 was placed in a pail and cooled to a solid state.

### [Manufacturing example 1]

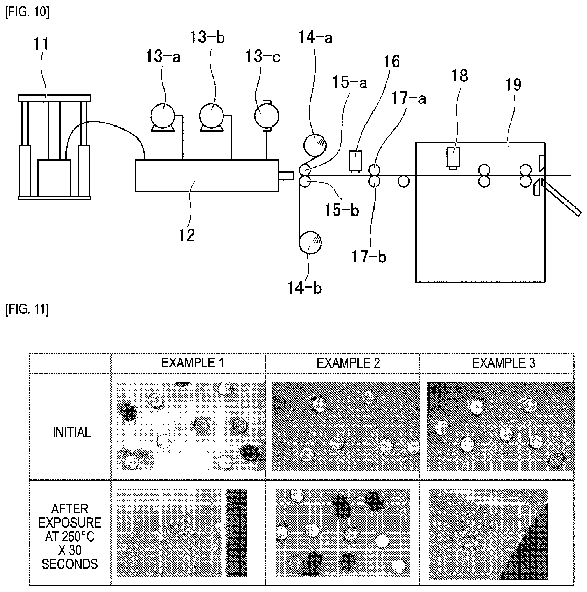

The resulting hot-melt mixture 1 obtained in Reference Example 1 was fed into a twin-screw extruder at 170°C by a hot-melter (VersaPail Melter manufactured by Nordson) for cylindrical pails at 9.55 kg/hr from a line 11 as depicted in FIG. 10.

Next, a mixture of 0.30 kg/hr of the organohydrogenpolysiloxane expressed by the formula:

(PhSiO_{3/2})_{0.4} (HMe₂SiO_{1/2})_{0.6}

(amount of volatile components when aged in a 100°C oven under atmospheric pressure for one hour, in other words, the mass loss ratio was 3.4 mass%), and
methyltris-1,1-dimethyl-2-propynyloxysilane (boiling point = 245°C (1012.35 hPa)) at an amount of 300 ppm relative to the entire composition
was fed from the line 13-a as depicted in FIG. 10. The set temperature of the feeding part was 150°C.

Then, a mixture, containing
the dimethylpolysiloxane capped at both molecular terminals with dimethylvinylsiloxy groups (amount of vinyl groups = 0.09 mass%) expressed by

ViMe₂SiO(Me₂SiO)₈₀₀SiViMe₂

at a rate of 0.15 kg/hr, and
(methylcyclopentadienyl) trimethylplatinum (IV) (at an amount of 6.0 ppm based on mass units as platinum metal relative to the entire present composition), was fed from line 13-b in FIG. 10 (set temperature of introducing part was 80°C), and degassing melt-kneading was performed with the degree of vacuum in an extruder of -0.08 MPa.

The outlet temperature of the twin-screw extruder was set at 80°C. The mixture was in the form of semi-solid softened material. While transporting 330 mm wide and 125-µm-thick release films (FL2-01 manufactured by TAKARA INC. CO. Ltd.) at a rate of 1.0 m/min, the mixture was supplied onto a release film such that the feed rate was 5 kg/hr. The mixture was then interposed between two release films such that a release surface of the release film was in contact with the mixture to form a laminate body. Subsequently, the laminate body was then pressed between rollers with temperatures controlled at 90°C to stretch the mixture between the release films to form a laminate body in which a curable hot-melt silicone composition film having a thickness of 300 µm was interposed between the two release films. The entire laminate body was then cooled by air cooling. The configuration of the manufacturing device is depicted in FIG. 10. When the release film was released from the obtained laminate body, a flat, homogeneous, tack-free, transparent curable hot-melt silicone composition sheet without bubbles was obtained, and the softening temperature thereof was 85°C. The resulting curable hot-melt silicone composition film was irradiated with ultraviolet light with a 365 nm wavelength at an irradiation dose of 10 J/cm², and then the curability at 100°C was measured by the method described above. The ts-1 thereof was 59 seconds.

### Example 1

The hot melt silicone composition film (hereinafter, "silicone film") obtained in Manufacturing example 1 was used to evaluate the aforementioned adhesive properties and the thermal stability of the conductive pillar module precursor. The results are presented in Table 1. The obtained structure was placed in an oven set to 250°C for 30 seconds, and then the structure was visually inspected for warping and movement of the conductive pillars. The results are presented in FIG. 11.

### Example 2

Polyethylene terephthalate (PET) films were used to evaluate the aforementioned adhesive properties and thermal stability of the conductive pillar module precursors. The results are presented in Table 1. The obtained structure was placed in an oven set to 250°C for 30 seconds, and then the structure was visually inspected for warping and movement of the conductive pillars. The results are presented in FIG. 11.

### Example 3

Polyimide (PI) films were used to evaluate the aforementioned adhesive properties and thermal stability of the conductive pillar module precursors. The results are presented in Table 1. The obtained structure was placed in an oven set to 250°C for 30 seconds, and then the structure was visually inspected for warping and movement of the conductive pillars. The results are presented in FIG. 11.

**[Table 1]**

| | | Example 1 | Example 2 | Example 3 |
|---|---|---|---|---|
| Adhesion properties of film samples | Initial | 9.4 MPa | 17.6 MPa | 13.3 MPa |
| | 85°C, humidity 85% for 336 hours | 10.6 MPa | 15.8 MPa | 13.6 MPa |
| | -40°C ⇔125°C 500 cycles | 10.2 MPa | 8.4 MPa | 9.3 MPa |
| Thermal stability of conductive pillar module precursor for semiconductor manufacturing | [FIG. 11] Initial results ⇒ Results after 30 seconds of exposure at 250°C | After exposure to 250°C, no movement of the conductive pillars and no warping of the silicone film was observed | After exposure to 250°C, the conductive pillars were found to have moved and the PET film was warped | After exposure to 250°C, there was no movement of the conductive pillars, but warping of the PI filmwas observed |

The results in Table 1 show that silicone films do not lose adhesive properties to copper even after humidity aging or thermal cycling, whereas PET and polyimide show a decrease in adhesive strength to copper after durability testing. Furthermore, the results of Table 1 and FIG. 11 show that conductive pillar module precursors for semiconductor manufacturing can be manufactured using any of a silicone film, a PET film, or a polyimide film. However, when exposed for a short period of time to a temperature (250°C) similar to that applied in the reflow process, the pillars in the PET film moved and the film was warped, while the pillars in the polyimide film did not move but the film was warped. These results show that silicone film is most suitable for manufacturing conductive pillar module precursors for semiconductor manufacturing.

### INDUSTRIAL APPLICABILITY

The conductive pillar module precursor for semiconductor manufacturing of the present invention can be used in semiconductor manufacturing for secondary wiring to a substrate of a flip chip package or for forming a redistribution layer (RDL) in a chip-last (RDL-first) package.

### REFERENCE NUMERALS

A. Conductive pillar module precursor for semiconductor manufacturing
1. Curable resin composition
1'. Cured resin material
2. Conductive pillar member
3. Substrate
4. Semiconductor chip
5. Conductive layer (relocation layer)
6. Mold underfill
7. Molded member
8. Release liner
9. Carrier member
11. Hot melter
12. Extruder
13-a. Powder feeder
13-b. Pump
13-c. Pump
14-a. Release sheet
14-b. Release sheet
15-a. Stretching roller (optionally further equipped with a temperature control function)
15-b. Stretching roller (optionally further equipped with a temperature control function)
16. Film thickness meter
17-a...Cooling roller
17-b...Cooling roller
18. Sheet cutter
19. Foreign material inspecting machine

## Claims

1. A conductive pillar module precursor for semiconductor manufacturing, comprising: a conductive pillar member supported by a sheet-like cured resin material.

2. The conductive pillar module precursor for semiconductor manufacturing according to claim 1, wherein the sheet-like cured resin material is a silicone cured material, and the conductive pillar member is a conductive pillar having a minor axis length of 50 to 500 µm and a major axis length of 50 to 500 µm.

3. The conductive pillar module precursor for semiconductor manufacturing according to claim 1, wherein the sheet-like cured resin material is a silicone cured material obtained by curing through a hydrosilylation reaction, and the conductive pillar member is a cylindrical copper pillar having a diameter of 50 to 500 µm and a height of 50 to 2000 µm.

4. A conductive pillar module for semiconductor manufacturing, comprising: a structure where a sheet-shaped cured resin material is supported by a conductive pillar member, and the conductive pillar member is exposed from both sides of the sheet-like cured resin material.

5. A semiconductor or semiconductor precursor, comprising: a structure in which at least a portion of the conductive pillar members of the conductive pillar module for semiconductor manufacturing described in claim 4 are soldered onto a substrate, and the conductive pillars exposed from the opposite surface of the sheet-like cured resin material are bonded to a semiconductor chip directly or via a conductive layer (redistribution layer).

6. The semiconductor or semiconductor precursor according to claim 5, further comprising a structure in which gaps between the substrate, the semiconductor chip and the conductive pillar members are filled with a mold underfill material.

7. A method for manufacturing a semiconductor or a semiconductor precursor, comprising: a step of bonding a conductive pillar member exposed from the conductive pillar module precursor for semiconductor manufacturing according to claim 1 to a semiconductor chip or a substrate.

8. A method for manufacturing a conductive pillar module precursor for semiconductor manufacturing according to claim 1, comprising: the following steps (I) to (IV):
Step (I): a step of providing a conductive pillar member on a mold member;
Step (II): a step of providing at least one curable resin composition and, optionally, a release liner on the conductive pillar member;
Step (III): a step of curing the curable resin composition into a sheet shape by one or more curing means selected from heating and high energy beam radiation; and
Step (IV): a step of removing the optional release liner, and separating the conductive pillar module precursor for semiconductor manufacturing from the mold member.

9. A method for manufacturing a conductive pillar module precursor for semiconductor manufacturing according to claim 8, wherein
the curable resin composition used in Step (II) is a sheet of the curable resin composition having heat-melting properties, the sheet of the curable resin composition is placed on a conductive pillar member, and then the sheet of the curable resin composition is heated and melted to support at least a portion of the conductive pillar inside the sheet of the curable resin composition.

10. A method for manufacturing a conductive pillar module precursor for semiconductor manufacturing according to claim 8, wherein
the curable resin composition used in Step (II) is a hydrosilylation reaction-curable silicone sheet having heat-melting properties, and the hydrosilylation reaction-curable silicone sheet is placed on a conductive pillar member, and then the hydrosilylation reaction-curable silicone sheet is heated and melted to support at least a portion of the conductive pillar member inside the curable resin composition sheet, and
Step (III) is a step of curing the hydrosilylation-curable silicone sheet into a sheet form by one or more curing means selected from the group consisting of heating and high-energy beam radiation.

11. The method for manufacturing a conductive pillar module precursor for semiconductor manufacturing according to claim 8, further comprising a step of: after the aforementioned Step (IV), a step of bonding the optionally exposed conductive pillar member to a semiconductor chip or substrate, and then scraping off at least one surface of the sheet-like cured resin material to expose the conductive pillar on both surfaces of the sheet-like cured resin.

12. A method for manufacturing a conductive pillar module precursor for semiconductor manufacturing according to claim 1, comprising the following steps (I') to (V'):
Step (I'): a step of providing a conductive pillar member on a first mold member;
Step (II'): a step of placing a second mold member on the conductive pillar member;
Step (III'): a step of filling gaps between the conductive pillar member, the first molding member, and the second molding member with a curable resin composition;
Step (IV'): a step of curing the curable resin composition into a sheet shape by one or more curing means selected from heating and high energy beam radiation; and
Step (V'): a step of separating the first molding member and the second molding member from the conductive pillar module precursor for semiconductor manufacturing.

13. A method for manufacturing a semiconductor or a semiconductor precursor, comprising the following steps (L1) to (L5):
Step (L1): a step of adhering the conductive pillar module precursor for semiconductor manufacturing according to claim 1 to a carrier member;
Step (L2): a step of bonding a semiconductor chip to a conductive pillar member on one side of the conductive pillar module precursor for semiconductor manufacturing, with the conductive pillar member being exposed from the sheet-like cured resin material;
Step (L3): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4): a step of soldering the conductive pillar member exposed in step (L3) to a substrate; and
Step (L5): a step of filling the gaps between the substrate, the semiconductor chip, and the conductive pillar member with a mold underfill material.

14. A method for manufacturing a semiconductor or a semiconductor precursor, comprising the following steps (L1') to (L5'):
Step (L1'): a step of adhering the conductive pillar module precursor for semiconductor manufacturing according to claim 1 to a carrier member;
Step (L2'): a step of bonding to the substrate by soldering the conductive pillar member on one side of the conductive pillar module precursor for semiconductor manufacturing, the conductive pillar member being exposed from the sheet-like cured resin material;
Step (L3'): a step of removing the carrier member from the conductive pillar module precursor for semiconductor manufacturing, and then scraping off at least one surface of the sheet-like cured resin material to expose the conductive pillar on the surface of the sheet-like cured resin material;
Step (L4'): a step of bonding the conductive pillar exposed in step (L3') to a semiconductor chip, either directly or via a conductive layer (redistribution layer); and
Step (L5'): a step of filling the gaps between the substrate, the semiconductor chip, and the conductive pillar with a mold underfill material.
